(19)

Europäisches Patentamt

European Patent Office

Office européen des brevets

(11) **EP 3 910 418 A1**

(12) **EUROPEAN PATENT APPLICATION**

(43) Date of publication:
**17.11.2021 Bulletin 2021/46**

(51) Int Cl.:
***G03F 7/20*** (2006.01)    ***G06T 7/00*** (2017.01)

(21) Application number: **20174556.9**

(22) Date of filing: **14.05.2020**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
• **BATISTAKIS, Chrysostomos**
**5500 AH Veldhoven (NL)**

• **PISARENCO, Maxim**
**5500 AH Veldhoven (NL)**
• **OYARZUN RIVERA, Bernardo Andres**
**5500 AH V (NL)**
• **SLACHTER, Abraham**
**5500 AH Veldhoven (NL)**

(74) Representative: **ASML Netherlands B.V.**
**Corporate Intellectual Property**
**P.O. Box 324**
**5500 AH Veldhoven (NL)**

(54) **METHOD FOR DIRECT DECOMPOSITION OF STOCHASTIC CONTRIBUTORS**

(57)    Described herein is a method for decomposing error contributions from multiple sources to multiple features of a pattern printed on a substrate. The method includes obtaining an image of the pattern on the substrate and obtaining, using the image, a plurality of measurement values (615;620;625) of a feature of the pattern. The measurement values are obtained for different sensor values. Further, the method includes correlating, using a decomposition algorithm (320), each measurement value of the plurality of measurement values to a linear mixture of the error contributions to generate a plurality of linear mixtures of the error contributions, and deriving, from the linear mixtures and using the decomposition algorithm, each of the error contributions (601;602;603).

FIG. 6

**Description**

TECHNICAL FIELD

The description herein relates to lithographic apparatuses and processes, and more particularly to a tool to determine stochastic variations in printed patterns (e.g., in a mask or resist layer on a wafer) which can be used to detect defects (e.g., on a mask or a wafer) and optimize a patterning process such as mask optimization and source optimization.

BACKGROUND

A lithographic apparatus is a machine that applies a desired pattern onto a target portion of a substrate. The lithographic apparatus can be used, for example, in the manufacture of integrated circuits (ICs). For example, an IC chip in a smart phone, can be as small as a person's thumbnail, and may include over 2 billion transistors. Making an IC is a complex and time-consuming process, with circuit components in different layers and including hundreds of individual steps. Errors in even one step have the potential to result in problems with the final IC and can cause device failure. High process yield and high wafer throughput can be impacted by the presence of defects, especially if operator intervention is required for reviewing the defects. Inspection tools (such as an optical or electron microscope (SEM)) are used in identification of the defects to help in maintaining high yield and low cost.

BRIEF SUMMARY

In an embodiment, there is provided a non-transitory computer-readable media comprising instructions that, when executed by a computer, cause the computer to execute a method for decomposing error contributions from multiple sources to multiple features of a pattern printed on a substrate. The method includes obtaining an image of the pattern on the substrate; obtaining, using the image, a plurality of measurement values of a feature of the pattern, wherein the measurement values are obtained for different sensor values; correlating, using a decomposition method, each measurement value of the plurality of measurement values to a linear mixture of the error contributions to generate a plurality of linear mixtures of the error contributions; and deriving, from the linear mixtures and using the decomposition method, each of the error contributions.

In an embodiment, there is provided a non-transitory computer-readable media comprising instructions that, when executed by a computer, cause the computer to execute a method for decomposing error contributions from multiple sources to multiple features of a pattern printed on a substrate. The method includes obtaining an image of the pattern; obtaining a plurality of delta critical dimension (CD) values at different heights of contours of the features of the pattern, wherein the plurality of delta CD values includes (a) a first set of delta CD values of the features corresponding to a first contour height, (b) a second set of delta CD values of the features corresponding to a second contour height, and (c) a third set of delta CD values of the features corresponding a third contour height; correlating, using a decomposition method, (a) the first set of delta CD values to a first linear mixture of a first, second, and third error contributions, (b) the second set of delta CD values to a second linear mixture of the first, second, and third error contributions, (c) the third set of delta CD values to a third linear mixture of the first, second, and third error contributions; and deriving, from the linear mixtures and using the decomposition method, the first, second, and third error contributions.

Furthermore, in an embodiment, there is provided a non-transitory computer-readable media comprising instructions that, when executed by a computer, cause the computer to execute a method for decomposing error contributions from multiple sources to multiple features of a pattern printed on a substrate. The method includes obtaining local critical dimension uniformity (LCDU) data associated with the pattern, wherein the LCDU data includes, for a specified focus level of a source of a lithographic apparatus used to print the pattern, (a) a first set of LCDU values of the features of the pattern corresponding to a first dose level of the source, (b) a second set of LCDU values of the features corresponding to a second dose level, and (c) a third set of LCDU values of the features corresponding a third dose level; correlating, using a decomposition method, (a) the first set of LCDU values to a first linear mixture of a first, second, and third error contributions, (b) the second set of LCDU values to a second linear mixture of the first, second, and third error contributions, and (c) the third set of LCDU values to a third linear mixture of the first, second, and third error contributions; and deriving, from the linear mixtures and using the decomposition method, the first, second, and third error contributions.

Furthermore, in an embodiment, there is provided a method for decomposing error contributions from multiple sources to multiple features associated with a pattern to be printed on a substrate. The method includes obtaining an image of the pattern on the substrate; obtaining, using the image, a plurality of measurement values of a feature of the pattern, wherein the measurement values correspond to different threshold values associated with the image; correlating, using a decomposition method, each measurement value of the plurality of measurement values to a linear mixture of the error contributions to generate a plurality of linear mixtures of the error contributions; and deriving, from the linear mixtures and using the decomposition method, each of the error contributions.

Furthermore, in an embodiment, there is provided a method for decomposing error contributions from multiple sources to one or more features associated with a pattern printed on a substrate. The method includes obtaining local critical dimension uniformity (LCDU) data associated with the pattern, wherein the LCDU data includes, for a specified focus level of a source of a lithographic apparatus used to print the pattern, (a) a first set of LCDU values of one or more features of the pattern corresponding to a first dose level of the source, (b) a second set of LCDU values of the one or more features corresponding to a second dose level, and (c) a third set of LCDU values of the one or more features corresponding a third dose level; correlating, using a decomposition method, (a) the first set of LCDU values to a first linear mixture of a first, second, and third error contributions, (b) the second set of LCDU values to a second linear mixture of the first, second, and third error contributions, and (c) the third set of LCDU values to a third linear mixture of the first, second, and third error contributions; and deriving, from the linear mixtures and using the decomposition method, the first, second, and third error contributions.

Furthermore, in an embodiment, there is provided an apparatus for decomposing error contributions from multiple sources to multiple features of a pattern printed on a substrate. The apparatus includes a memory storing a set of instructions; and at least one processor configured to execute the set of instructions to cause the apparatus to perform a method of: obtaining an image of the pattern on the substrate; obtaining, using the image, a plurality of measurement values of a feature of the pattern, wherein the measurement values are obtained for different sensor values; correlating, using a decomposition method, each measurement value of the plurality of measurement values to a linear mixture of the error contributions to generate a plurality of linear mixtures of the error contributions; and deriving, from the linear mixtures and using the decomposition method, each of the error contributions.

Furthermore, in an embodiment, there is provided a computer program product comprising a non-transitory computer readable medium having instructions recorded thereon, the instructions when executed by a computer system implementing the aforementioned methods.

BRIEF DESCRIPTION OF THE DRAWINGS

Embodiments will now be described, by way of example only, with reference to the accompanying drawings in which:

Figure 1 is a block diagram of various subsystems of a lithography system, according to an embodiment.
Figure 2 is a block diagram of simulation models corresponding to the subsystems in Figure 1, according to an embodiment.
Figure 3 is a block diagram for decomposing data using independent component analysis (ICA), according to an embodiment.
Figure 4 is a block diagram showing an example scanning electron microscope (SEM) image and a graph of critical dimension (CD) values of contact holes printed on a substrate, according to an embodiment.
Figure 5 shows a graph of measurement values of a feature corresponding to multiple thresholds obtained at multiple measurement points, according to an embodiment.
Figure 6 is a block diagram illustrating a decomposer module decomposing measurement data associated with a feature to obtain the error contributors, according to an embodiment.
Figure 7A is a graph of LCDU data used for decomposing error contributors, according to an embodiment.
Figure 7B is another graph of LCDU data used for decomposing error contributors, according to an embodiment.
Figure 8A is a flow diagram of a process for decomposing measurement values of a feature to derive error contributions from multiple sources, according to an embodiment.
Figure 8B is a flow diagram of a process for deriving error contributions from linear mixtures using ICA, according to an embodiment.
Figure 9 is a flow diagram of a process for obtaining measurement values for the decomposition process of FIG. 8A, according to an embodiment.
Figure 10 is a diagram showing a process for obtaining measurement values of a contour for various thresholds, according to an embodiment.
Figure 11 schematically depicts an embodiment of a SEM, according to an embodiment.
Figure 12 schematically depicts an embodiment of an electron beam inspection apparatus, according to an embodiment.
Figure 13 is a flow diagram illustrating aspects of an example methodology of joint optimization, according to an embodiment.
Figure 14 shows an embodiment of another optimization method, according to an embodiment.
Figures 15A, 15B and 16 show example flowcharts of various optimization processes, according to an embodiment.
Figure 17 is a block diagram of an example computer system, according to an embodiment.

Figure 18 is a schematic diagram of a lithographic projection apparatus, according to an embodiment.
Figure 19 is a schematic diagram of another lithographic projection apparatus, according to an embodiment.
Figure 20 is a more detailed view of the apparatus in Figure 19, according to an embodiment.
Figure 21 is a more detailed view of the source collector module SO of the apparatus of Figures 19 and 20, according to an embodiment.

Embodiments will now be described in detail with reference to the drawings, which are provided as illustrative examples so as to enable those skilled in the art to practice the embodiments. Notably, the figures and examples below are not meant to limit the scope to a single embodiment, but other embodiments are possible by way of interchange of some or all of the described or illustrated elements. Wherever convenient, the same reference numbers will be used throughout the drawings to refer to same or like parts. Where certain elements of these embodiments can be partially or fully implemented using known components, only those portions of such known components that are necessary for an understanding of the embodiments will be described, and detailed descriptions of other portions of such known components will be omitted so as not to obscure the description of the embodiments. In the present specification, an embodiment showing a singular component should not be considered limiting; rather, the scope is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. Further, the scope encompasses present and future known equivalents to the components referred to herein by way of illustration.

DETAILED DESCRIPTION

A lithographic apparatus is a machine that applies a desired pattern onto a target portion of a substrate. This process of transferring the desired pattern to the substrate is called a patterning process. The patterning process can include a patterning step to transfer a pattern from a patterning device (such as a mask) to the substrate. Also, there can then be one or more related pattern processing steps, such as resist development by a development apparatus, baking of the substrate using a bake tool, etching the pattern onto the substrate using an etch apparatus, etc. Various variations (e.g., stochastic variations, errors or noises due to any of inspection tool, mask or resist) can potentially limit lithography implementation for semiconductor high volume manufacturing (HVM). In order to characterize, understand and determine such variation, the industry needs a trustworthy method to measure such variation for variety of design patterns.

Existing approaches of measuring stochastic variations involve different measurement techniques for different design patterns. In order to prepare data for determining variations using existing technologies, dedicated experiments are performed, which include printing the design pattern on the substrate (e.g., for the purpose of taking the measurements and not for manufacturing a device to sell), obtaining images of the pattern printed on the substrate using an inspection tool, such as a scanning electron microscope (SEM), analyzing the SEM images to obtain the measurement data, and repeating the above measurement process multiple times. To acquire a good quality SEM image at defined locations on the substrate, the inspection tool has to perform focus adjustment and alignment for each repetition, which is not only time consuming, but also increases the chances of damaging the substrate. The above existing approach can be time consuming and cost prohibitive, can cause damage to resist due to measurement repeats, and can consume significant computing and manufacturing resources.

Some embodiments of the present disclosure derive the stochastic variations using independent component analysis (ICA) methods. Some of the advantages of the disclosed methods include eliminating the need for performing dedicated experiments and multiple repeats and minimizing a number of SEM images required for the decomposition (typically with significantly lesser number of SEM images than required by the prior known methods) of the stochastic variations.

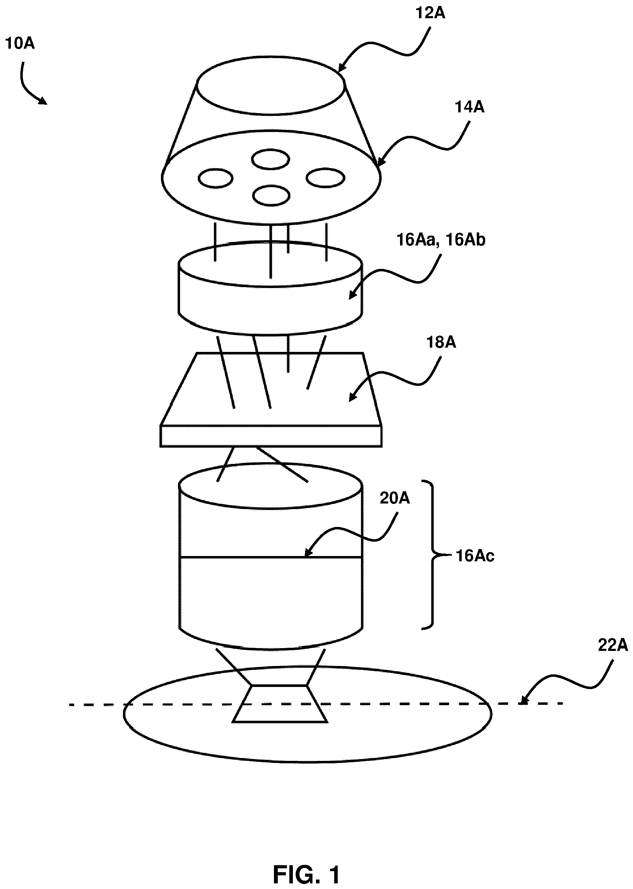

As a brief introduction, Figure 1 illustrates an exemplary lithographic projection apparatus 10A.

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as interchangeable with the more general terms "mask", "substrate" and "target portion", respectively.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range 5-20 nm).

The term "optimizing" and "optimization" as used herein mean adjusting a lithographic projection apparatus such that results or processes of lithography have more desirable characteristics, such as higher accuracy of projection of design layouts on a substrate, larger process windows, etc.

Further, the lithographic projection apparatus may be of a type having two or more substrate tables (or two or more patterning device tables). In such "multiple stage" devices the additional tables may be used in parallel, or preparatory steps may be carried out on one or more tables while one or more other tables are being used for exposures. Twin stage lithographic projection apparatuses are described, for example, in US 5,969,441, incorporated herein by reference.

The patterning device referred to above comprises or can form design layouts. The design layouts can be generated utilizing CAD (computer-aided design) programs, this process often being referred to as EDA (electronic design automation). Most CAD programs follow a set of predetermined design rules in order to create functional design layouts/patterning devices. These rules are set by processing and design limitations. For example, design rules define the space tolerance between circuit devices (such as gates, capacitors, etc.) or interconnect lines, so as to ensure that the circuit devices or lines do not interact with one another in an undesirable way. The design rule limitations are typically referred to as "critical dimensions" (CD). A critical dimension of a circuit can be defined as the smallest width of a line or hole or the smallest space between two lines or two holes. Thus, the CD determines the overall size and density of the designed circuit. Of course, one of the goals in integrated circuit fabrication is to faithfully reproduce the original circuit design on the substrate (via the patterning device).

The term "mask" or "patterning device" as employed in this text may be broadly interpreted as referring to a generic patterning device that can be used to endow an incoming radiation beam with a patterned cross-section, corresponding to a pattern that is to be created in a target portion of the substrate; the term "light valve" can also be used in this context. Besides the classic mask (transmissive or reflective; binary, phase-shifting, hybrid, etc.), examples of other such patterning devices include:

- a programmable mirror array. An example of such a device is a matrix-addressable surface having a viscoelastic control layer and a reflective surface. The basic principle behind such an apparatus is that (for example) addressed areas of the reflective surface reflect incident radiation as diffracted radiation, whereas unaddressed areas reflect incident radiation as undiffracted radiation. Using an appropriate filter, the said undiffracted radiation can be filtered out of the reflected beam, leaving only the diffracted radiation behind; in this manner, the beam becomes patterned according to the addressing pattern of the matrix-addressable surface. The required matrix addressing can be performed using suitable electronic means. More information on such mirror arrays can be gleaned, for example, from U. S. Patent Nos. 5,296,891 and 5,523,193, which are incorporated herein by reference.
- a programmable LCD array. An example of such a construction is given in U. S. Patent No. 5,229,872, which is incorporated herein by reference.

Major components are a radiation source 12A, which may be a deep-ultraviolet excimer laser source or other type of source including an extreme ultra violet (EUV) source (as discussed above, the lithographic projection apparatus itself need not have the radiation source), illumination optics which define the partial coherence (denoted as sigma) and which may include optics 14A, 16Aa and 16Ab that shape radiation from the source 12A; a patterning device 14A; and transmission optics 16Ac that project an image of the patterning device pattern onto a substrate plane 22A. An adjustable filter or aperture 20A at the pupil plane of the projection optics may restrict the range of beam angles that impinge on the substrate plane 22A, where the largest possible angle defines the numerical aperture of the projection optics $NA=\sin(\Theta_{max})$.

In an optimization process of a system, a figure of merit of the system can be represented as a cost function. The optimization process boils down to a process of finding a set of parameters (design variables) of the system that minimizes the cost function. The cost function can have any suitable form depending on the goal of the optimization. For example, the cost function can be weighted root mean square (RMS) of deviations of certain characteristics (evaluation points) of the system with respect to the intended values (e.g., ideal values) of these characteristics; the cost function can also be the maximum of these deviations (i.e., worst deviation). The term "evaluation points" herein should be interpreted broadly to include any characteristics of the system. The design variables of the system can be confined to finite ranges or be interdependent due to practicalities of implementations of the system. In case of a lithographic projection apparatus, the constraints are often associated with physical properties and characteristics of the hardware such as tunable ranges, or patterning device manufacturability design rules, and the evaluation points can include physical points on a resist image on a substrate, as well as non-physical characteristics such as dose and focus.

In a lithographic projection apparatus, a source provides illumination (i.e. light); projection optics direct and shapes the illumination via a patterning device and onto a substrate. The term "projection optics" is broadly defined here to include any optical component that may alter the wavefront of the radiation beam. For example, projection optics may include at least some of the components 14A, 16Aa, 16Ab and 16Ac. An aerial image (AI) is the radiation intensity distribution at substrate level. A resist layer on the substrate is exposed and the aerial image is transferred to the resist layer as a latent "resist image" (RI) therein. The resist image (RI) can be defined as a spatial distribution of solubility of the resist in the resist layer. A resist model can be used to calculate the resist image from the aerial image, an example of which can be found in commonly assigned U.S. Patent Application Serial No. 12/315,849, disclosure of which is hereby incorporated by reference in its entirety. The resist model is related only to properties of the resist layer (e.g., effects of chemical processes which occur during exposure, PEB and development). Optical properties of the lithographic projection apparatus (e.g., properties of the source, the patterning device and the projection optics) dictate the aerial image. Since the patterning device used in the lithographic projection apparatus can be changed, it is desirable to separate the optical properties of the patterning device from the optical properties of the rest of the lithographic projection apparatus including at least the source and the projection optics.

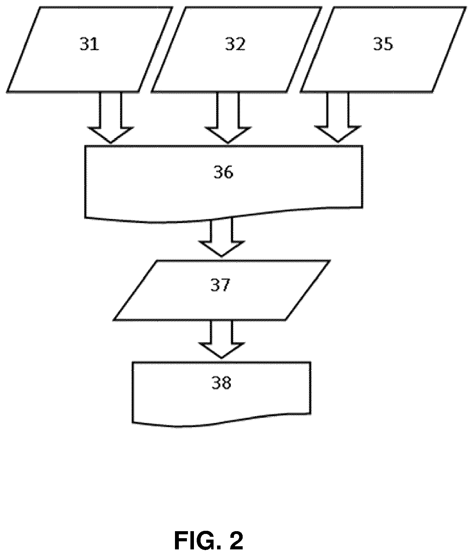

An exemplary flow chart for simulating lithography in a lithographic projection apparatus is illustrated in Figure 2. A source model 31 represents optical characteristics (including radiation intensity distribution or phase distribution) of the source. A projection optics model 32 represents optical characteristics (including changes to the radiation intensity distribution or the phase distribution caused by the projection optics) of the projection optics. A design layout model 35 represents optical characteristics (including changes to the radiation intensity distribution or the phase distribution caused by a given design layout 33) of a design layout, which is the representation of an arrangement of features on or formed by a patterning device. An aerial image 36 can be simulated from the design layout model 35, the projection optics model 32 and the design layout model 35. A resist image 38 can be simulated from the aerial image 36 using a resist model 37. Simulation of lithography can, for example, predict contours and CDs in the resist image.

More specifically, it is noted that the source model 31 can represent the optical characteristics of the source that include, but are not limited to, NA-sigma ($\sigma$) settings as well as any particular illumination source shape (e.g. off-axis radiation sources such as annular, quadrupole, and dipole, etc.). The projection optics model 32 can represent the optical characteristics of the of the projection optics that include aberration, distortion, refractive indexes, physical sizes, physical dimensions, etc. The design layout model 35 can also represent physical properties of a physical patterning device, as described, for example, in U.S. Patent No. 7,587,704, which is incorporated by reference in its entirety. The objective of the simulation is to accurately predict, for example, edge placements, aerial image intensity slopes and CDs, which can then be compared against an intended design. The intended design is generally defined as a pre-OPC design layout which can be provided in a standardized digital file format such as GDSII or OASIS or other file format.

From this design layout, one or more portions may be identified, which are referred to as "clips". In an embodiment, a set of clips is extracted, which represents the complicated patterns in the design layout (typically about 50 to 1000 clips, although any number of clips may be used). As will be appreciated by those skilled in the art, these patterns or clips represent small portions (e.g. circuits, cells or patterns) of the design and especially the clips represent small portions for which particular attention or verification is needed. In other words, clips may be the portions of the design layout or may be similar or have a similar behavior of portions of the design layout where critical features are identified either by experience (including clips provided by a customer), by trial and error, or by running a full-chip simulation. Clips usually contain one or more test patterns or gauge patterns.

An initial larger set of clips may be provided a priori by a customer based on known critical feature areas in a design layout which require particular image optimization. Alternatively, in another embodiment, the initial larger set of clips may be extracted from the entire design layout by using some kind of automated (such as, machine vision) or manual method that identifies the critical feature areas.

Stochastic variations of the patterning process (e.g., resist process) potentially limit EUV lithography implementation for semiconductor high volume manufacturing (HVM) because of the combination of "few" photons per millijoule dose and preferred low dose processes, for example, in terms of shrink potential of features and exposure-dose specification, which in turn affects product yield or wafer throughput of the patterning process or both. In an embodiment, stochastic variations of a resist layer may manifest in different failure modes described by, for example, line width roughness (LWR), line edge roughness (LER), local CD non-uniformity, closed holes or trenches, or broken lines at the extreme condition. Such stochastic variations impact and limit successful high volume manufacturing (HVM). In order to characterize, understand and predict stochastic variation, the industry needs a trustworthy method to measure such variation for variety of design patterns.

Existing approaches of measuring stochastic variation involve different measurement techniques for different features. For example, line/space are measured in one direction (e.g., x or y), a contact hole or an array of contact holes patterns printed on a substrate may be measured in two directions (e.g., x and y). As an example of measures, a pattern measure is a line width roughness (LWR) (an example of one directional measurement), and a repeating dense contact array measure is local CD uniformity (LCDU) (an example of a two directional measurement). Various stochastic contributors cause variations in the LWR/LCDU of the features.

In order to control, reduce and predict the stochastic contributors, the semiconductor industry needs a robust solution to measure them accurately. Currently, the industry measures LWR for a line and LCDU for repeating a contact array to estimate the stochastic contributors. Moreover, these measures only focus on pattern level (e.g., one number per pattern) but not on edge point level (e.g., points along a contour of a pattern) where a hot spot occurs.

In an embodiment, a metrology tool such as scanning electron microscope (SEM) is used to characterize the stochastic contributors associated with the desired pattern. In SEM image data captured by the SEM tool, noise is embedded therein. In an embodiment, SEM images may be analyzed to determine a CD of a feature (e.g., CD of a contact hole), delta CD, which is a deviation of the CD from a mean of the CD distribution, and LCDU of the contact holes. In an embodiment, the term "local" (e.g., in LCDU) may refer to a particular area (e.g., a unit cell or a particular die. In an embodiment, the CD of a contact hole or the LCDU may be affected by a number of contributors including: (i) SEM noise (or SEM error contribution), $\delta CD_{SEM,}$ (ii) mask noise (or mask error contribution), $\delta CD_{MASK}$. and (iii) resist noise (or resist error contribution), $\delta CD_{RESIST}$. In the equation below, the CD of a measured contact hole can be expressed as:

$$CD = \overline{CD} + \delta CD_{MASK} + \delta CD_{RESIST} + \delta CD_{SEM} \ \ldots (1)$$

wherein $\overline{CD}$ is the mean CD of multiple contact holes.

The mask noise can originate from an error during mask manufacturing. The resist noise (also called shot noise) can originate from chemical layers in the resist together with a photon shot noise of a light source of a lithographic apparatus used in the printing the pattern on the substrate, and the SEM related noise can originate from the SEM (e.g., shot noise from electron flank). In existing technology, the decomposition of the noises can be performed based on a linear nested model. For example, contact hole's local critical dimension uniformity (LCDU) has various contributions including SEM noise, mask noise, and resist noise. In an embodiment, LCDU data can be provided to the linear nested model to decompose the three contributions.

In an embodiment, in order to prepare the data for the decomposition method using existing technologies, dedicated experiments are performed for taking the measurements, which include printing the design pattern on the substrate, using the same SEM metrology recipe twice to capture images of the pattern printed on the substrate, and enabling local alignment in the recipe to reduce SEM measurement location offset among different measurement repeats. Similar measurements may be performed among different dies. In an embodiment, anchor features (e.g., at a center of an area to be scanned) are usually included in the SEM's field of view (FOV) to help align SEM image among different measurements (and different dies).

In the disclosure, the term "repeat" used with reference to measurement of a substrate refers to multiple measurements taken at a specified location of the substrate using a specified metrology recipe. For example, repeat data refers to acquiring a plurality of images at a first location (e.g., center of a specified die) on the substrate at a specified metrology recipe (e.g., landing energy, probe current, scan rate, etc.). In an embodiment, at least two repeat data are generated from the plurality of images.

The disadvantages of existing technology include, but are not limited to, following. Dedicated experiments may need to be performed for obtaining the measurements, which is time consuming, cost prohibitive, consumes significant computing and manufacturing resources. The measurement process includes at least two repeats. Next, there exists a large (x,y,z) placement offset between any two measurement repeats. For example, when running the SEM metrology recipe multiple times, the recipe has to perform global and local alignment (e.g., wafer alignment) for each recipe run. Even with local alignment (which the reduces measurement throughput), the typical (x,y) placement error is approximately 10 nm. There exists a large variation in a time lag difference associated with the same die location, therefore large SEM-shrinkage uncertainty associated with resist of the substrate being measured. For example, when running the SEM metrology recipe twice, it is also hard to control the time lapse between a first measurement repeat and a second measurement repeat among different dies. The time lapse increases the shrinkage uncertainty between two measurement repeats. This shrinkage uncertainty will degrade the accuracy of the decomposition result such as the SEM noise, the mask noise, and the resist. There exist longer data acquisition time and higher chance of wafer damage. For example, to acquire a good quality SEM image at the defined locations on substrate, the metrology tool has to perform focus adjustment, global and local alignment for each recipe run. This leads longer acquisition time, and more chance for wafer damage. When running focus and local alignment with SEM beam, SEM beam can damage the wafer surface.

The present disclosure decomposes LWR/LCDU/CD distribution using independent component analysis (ICA) methods. Some of the advantages of the disclosed methods include eliminating the need for performing dedicated experiments and multiple repeats and minimizing a number of SEM images required for the decomposition (typically with significantly lesser number of SEM images than required by the prior known methods). Further, the disclosed methods perform the decomposition with less metrology measurement time and less wafer damage compared to existing methods. In an embodiment, the method uses a large FOV and high-throughput SEM tool (such as HMI), which can acquire SEM images covering large wafer area with short time. While the following embodiments for deriving error contributors are described with reference to CD distribution and LCDU data, the embodiments are not restricted to CD distribution and LCDU data, they can also be used to derive error contributions by decomposing LWR data of the features.

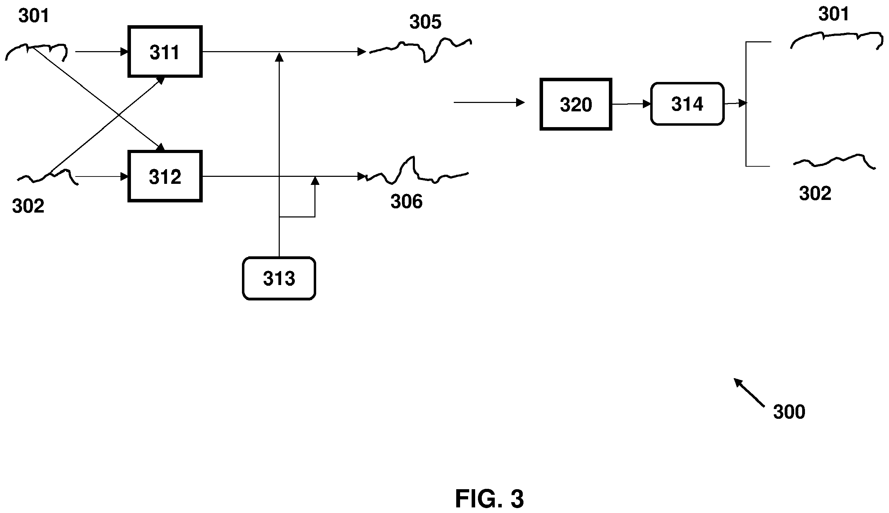

Figure 3 is a block diagram illustrating a method 300 for decomposing data using ICA, consistent with various embodiments. ICA is a known decomposition method in signal processing, however, it is briefly described below for convenience. ICA is a technique for blind source signal separation of linearly mixed signals, without having any information about the original signals. ICA attempts to decompose a multivariate signal into independent non-Gaussian signals. As an example, sound is usually a signal that is composed of the numerical addition, at each time t, of signals from several sources. The question then is whether it is possible to separate these contributing sources from the observed total signal. When the statistical independence assumption is correct, blind ICA separation of a mixed signal gives very good results.

A simple application of ICA is the "cocktail party problem", where the underlying speech signals (e.g., a first source signal 301 and a second source signal 302) are separated from a sample data consisting of people talking simultaneously in a room. The sample data can be different observations of different people talking simultaneously. For example, a first observation can be a first mixed signal 305 of both the source signals 301 and 302 output by a first sensor 311 (e.g., microphone) located at a first place in a room, and a second observation can be a second mixed signal 306 of both the source signals 301 and 302 output by a second sensor 312 (e.g., microphone) located in a second place different from the first place. A decomposer module 320, which is implemented based on the ICA method, can analyze the mixed signals 305 and 306 as linearly mixed signals, determine a mixing matrix (A) 313, and decompose the linearly mixed signals using unmixing matrix 314 to determine the original source signals 301 and 302.

In some embodiments, the ICA determines the mixing matrix as follows. In ICA, $n$ mixed signals (e.g., mixed signals 305 and 306) are represented as $n$ linear mixtures $x_1,...,x_n$ of $n$ independent components, s (e.g., source signals 301 and 302).

$$x_j = a_{j1}s_1 + a_{j2}s_2 + ... + a_{jn}s_n, \text{ for all } j \ ... \ (2)$$

In some embodiments, a linear mixture is a linear function of a set of coefficients and explanatory variables (independent variables), whose value is used to predict the outcome of a dependent variable. In the above Eq. 2, the dependent variable can be $x_j$, the set of coefficients can be $a_{j1}$- $a_{jn}$, and the explanatory variables can be $s_1$-$s_n$.

Let x denote the vector whose elements are the linear mixtures $x_1$-$x_n$, and likewise let s denote the vectors with elements $s_1$-$s_n$. Let A denote the matrix with the coefficients $a_{ij}$. Using this vector-matrix notation, the above mixing model may be written as

$$x = As \ ... \ (3)$$

or

$$x = \sum_{i=1}^{n} a_i s_i \ ... \ (4)$$

In some embodiments, the statistical model in Eq. 4 is called independent component analysis, or ICA model. The ICA model is a generative model, which means that it describes how the observed data are generated by a process of mixing the components $s_i$. The independent components are latent variables, meaning that they cannot be directly observed. Also, the mixing matrix (A) 313 is assumed to be unknown. All that is observed is the random vector x, and both A and s may be estimated using it. This must be done under as general assumptions as possible.

The ICA model performs a number of processes (e.g., linearly mixing the source signals, whitening the mixed signals, which are not described here for the sake of brevity) to determine the mixing matrix (A) 313. Then, after estimating the mixing matrix (A) 313, the inverse 314 of mixing matrix (A) 313, e.g., W, is obtained, which is then used to obtain the source component, s, by:

$$s = Wx \ ... \ (5)$$

In some embodiments, the ICA is based on two assumptions that (1) the source signals, $s_i$, are independent of each other, and (2) the values in each source signal, $s_i$, have non-Gaussian distributions. Further, in ICA, one of the constraints may be that if N sources are present, at least N observations (e.g. sensors or microphones) are needed to recover the original N signals. While the following paragraphs describe using three input signals to derive three error contributors, it should be noted that more than three input signals may be used to derive the three error contributors. In another example, if two error contributors are to be derived, then two or more input signals may be needed. In some embodiments, ICA method can be implemented using one of many algorithms, such as FastICA, infomax, JADE, and kernel-independent component analysis.

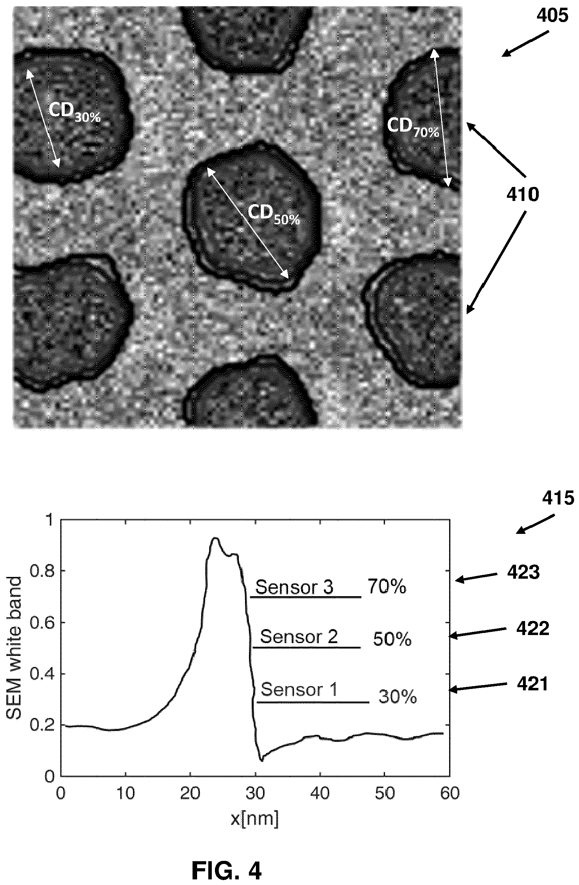

In some embodiments, the ICA method can be used in determining the error contributors, such as the $\delta CD_{MASK}$, $\delta CD_{RESIST}$, and $\delta CD_{SEM}$, to the LCDU/CD distribution of contact holes printed on the substrate, which is described below at least with reference to FIGs. 4-9. Note that the decomposition of the error contributors is not restricted to the ICA method, and other variations of the ICA method, such as the reconstruction ICA (RICA) method or the orthonormal ICA method can be used.

Figure 4 is a block diagram showing an example SEM image and a graph of CD values of contact holes printed on a substrate, according to an embodiment. The SEM image 405 can be an image of a design pattern printed on a substrate, which is obtained using an image acquisition tool such as a SEM. The design pattern printed on the substrate can include a number of features, such as the contact holes 410, illustrated in the SEM image 405. One or more measurement values may be obtained from the SEM image 405 using which each of the multiple error contributors, such as $\delta CD_{MASK}$, $\delta CD_{RESIST}$, and $\delta CD_{SEM}$, can be derived. Examples of such measurement values may include CD distribution (e.g., CD values or 8CD values), or LCDU, which are described in detail below.

In some embodiments, a contour of a contact hole 410 may be obtained using threshold values associated with the SEM image 405. For example, the SEM image 405 may be a grayscale image and a threshold value can be a pixel value (e.g., corresponding to a white band in the greyscale image), such as 30%, 50%, or 70% as shown in the graph 415. The graph 415 shows CD values of the contour of a contact hole for various threshold values (e.g., white band values). In some embodiments, if the value of white colored pixel is "1" and black colored pixel is "0," a threshold value of 30% of white band can be 30% of "1," which is "0.3." The position of a contour (e.g., contour height), and therefore, the CD of the contour may be obtained for that threshold value. In some embodiments, the threshold values correspond to the sensors described with respect to the ICA method in FIG. 3.

The position of the contour, and therefore, the CD of the contour are typically affected by the error contributors. Accordingly, the CD value of the contour for a first threshold value 421 (e.g., 30%) can be used as or in deriving a mixed signal that can be input to an ICA method to be decomposed for obtaining the error contributors to the CD distribution. In some embodiments, instead of using the CD value, a 8CD value may be used as the mixed signal that is input to the ICA method. In some embodiments, 8CD value of a contact hole can be a difference between the mean CD value and the CD value of the contact hole. In some embodiments, the mean CD value is a mean of CD values of a number of contact holes. Further, in some embodiment, 8CD value may be determined with the mean CD value shifted to "0" (which means the mean value is subtracted from the CD values of all the contact holes). In some embodiments, 8CD value of a contact hole can be a distance between a specified point on a contour of a contact hole to a reference point on a reference contour of the contact hole. The reference contour may be obtained from a target pattern, which is simulated from a mask pattern of the corresponding contact hole.

In some embodiments, the relationship between 8CD value of a contact hole and the error contributors may be expressed as:

$$\delta CD = \delta CD_{MASK} + \delta CD_{RESIST} + \delta CD_{SEM} \quad \ldots (6)$$

For decomposing the error contributors using the ICA, in some embodiments, the 8CD can be represented as a linear mixture of the error contributors as follows:

$$\delta CD = a11 * \delta CD_{MASK} + a12 * \delta CD_{RESIST} + a13 * \delta CD_{SEM} \quad \ldots (7)$$

where a11-a13 are set of coefficients of the linear mixture and part of the mixing matrix (A) 313 of the ICA.

The 8CD value may be used as an input to the ICA method. However, in some embodiments, since there are three error contributors at least three different 8CD values may be needed for the decomposition process as the ICA has a constraint that the number of mixed signals required as input has to be equal to or greater than the number of source components that need to be derived or decomposed. Accordingly, the $\delta CD$ values are obtained for three different threshold values of the white band, e.g., a first $\delta CD$ value, $\delta CD_{30\%}$, is obtained based on the CD value at the first threshold value 421 (e.g., 30% of the white band), a second $\delta CD$ value, $\delta CD_{50\%}$, is obtained based on the CD value at a second threshold value 422 (e.g., 50% of the white band), and a third $\delta CD$ value, $\delta CD_{70\%}$, is obtained based on the CD value at a third threshold value 423 (e.g., 70% of the white band). The three 8CD values can be represented as three different linear mixtures of the error contributors as follows:

$$\delta CD_{30\%} = a11 * \delta CD_{MASK} + a12 * \delta CD_{RESIST} + a13 * \delta CD_{SEM} \quad \ldots (8)$$

$$\delta CD_{50\%} = a21 * \delta CD_{MASK} + a22 * \delta CD_{RESIST} + a23 * \delta CD_{SEM} \quad \ldots (9)$$

$$\delta CD_{70\%} = a31 * \delta CD_{MASK} + a32 * \delta CD_{RESIST} + a33 * \delta CD_{SEM} \quad \dots (10)$$

$$\begin{bmatrix} \delta CD_{30\%} \\ \delta CD_{50\%} \\ \delta CD_{70\%} \end{bmatrix} = \begin{bmatrix} a_{11} & a_{12} & a_{13} \\ a_{21} & a_{22} & a_{23} \\ a_{31} & a_{32} & a_{33} \end{bmatrix} \cdot \begin{bmatrix} \delta CD_{MASK} \\ \delta CD_{RESIST} \\ \delta CD_{SEM} \end{bmatrix} \quad \dots (11)$$

where $A = \begin{bmatrix} a_{11} & a_{12} & a_{13} \\ a_{21} & a_{22} & a_{23} \\ a_{31} & a_{32} & a_{33} \end{bmatrix}$ I is the mixing matrix 313, and $\delta CD_{MASK}$, $\delta CD_{RESIST}$, and $\delta CD_{SEM}$ are a function of the error contributors in Eqs. 8-10. For example, $\delta CD_{MASK}$ can be considered as a mean of $\delta CD_{MASK(30\%)}$, $\delta CD_{MASK(50\%)}$, and $\delta CD_{MASK(700\%)}$ values, or $\delta CD_{MASK}$ can be considered as one of $\delta CD_{MASK(30\%)}$, $\delta CD_{MASK(50\%)}$, and $\delta CD_{MASK(70\%)}$ values.

While the above $\delta CD$ values, $\delta CD_{30\%}$, $\delta CD_{50\%}$, and $\delta CD_{70\%}$, are determined with respect to one measurement point, a number of such 8CD values are obtained for multiple measurement points for each of the three thresholds resulting in three different signals in which a first signal includes multiple $\delta CD_{30\%}$ values, a second signal includes multiple $\delta CD_{50\%}$ values, and a third signal includes multiple $\delta CD_{70\%}$, values.

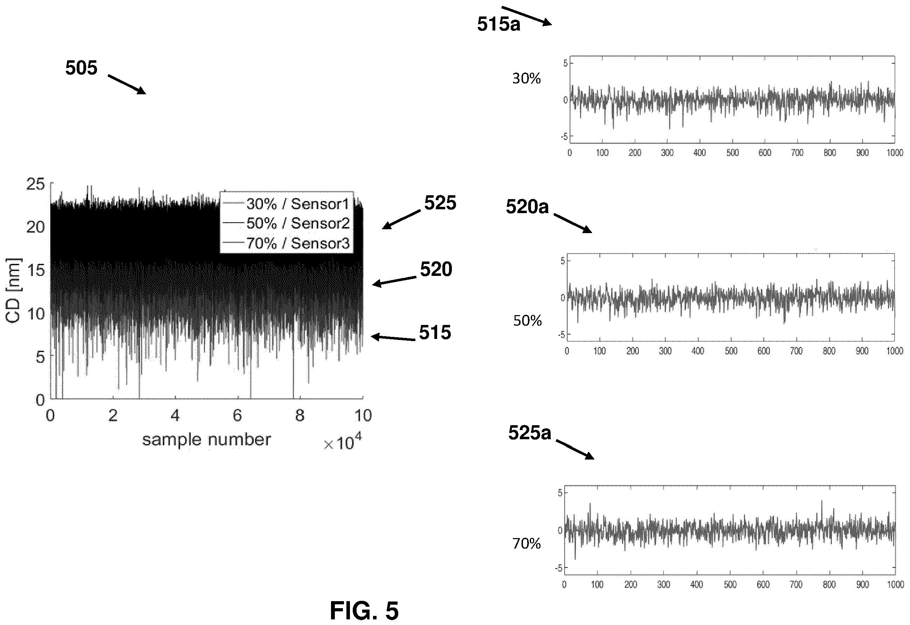

Figure 5 shows a graph of measurement values of the feature corresponding to each of the multiple thresholds obtained at multiple measurement points, according to an embodiment. The graph 505 shows CD values obtained at various measurement points for each of the three thresholds. For example, the graph 505 shows a first set of CD values 515 obtained at the first threshold value 421 of 30%, a second set of CD values 520 obtained at the second threshold value 422 of 50%, and a third set of CD values 525 obtained at the third threshold value 423 of 70%. Each set of CD values is a vector of CD values with the vector size being the number of measurement points. The sets of CD values are further processed (e.g., computing a mean and shifting the mean to "0") to obtain the 8CD values for each of the thresholds. For example, a first set of 8CD values 515a is obtained from the first set of CD values 515, a second set of 8CD values 520a is obtained from the second set of CD values 520, and a third set of 8CD values 525a is obtained from the third set of CD values 525. In some embodiments, each set of 8CD values may be input as a mixed signal to the decomposer module 320.

In some embodiments, the measurement points or metrology points (e.g., a point where the CD value is measured) can be on the same contact hole or on different contact holes.

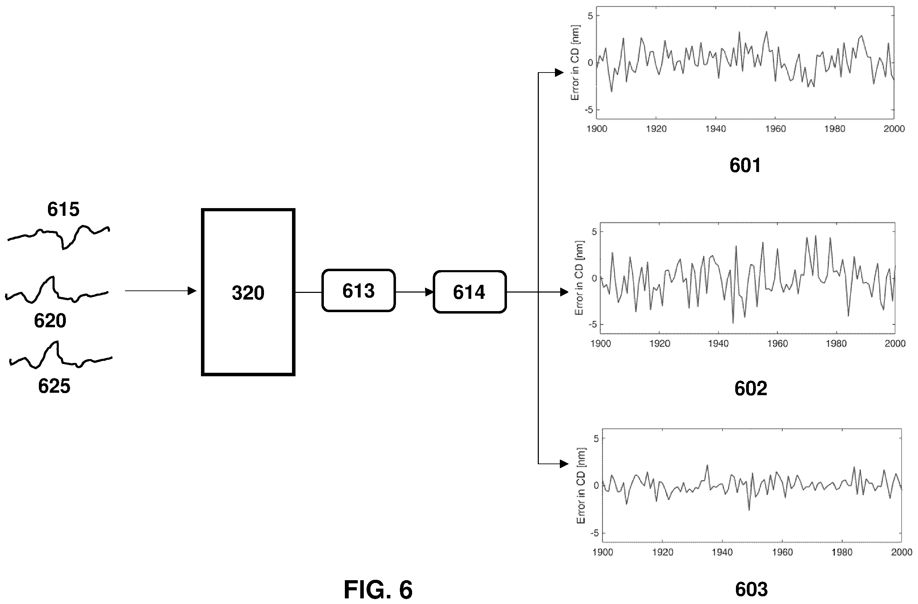

Figure 6 is a block diagram illustrating a decomposer module decomposing measurement data associated with a feature to obtain the error contributors, according to an embodiment. The decomposer module 320 decomposes measurement data, such as the CD distribution data, for obtaining the error contributors, such as the $\delta CD_{MASK}$, $\delta CD_{RESIST}$, and $\delta CD_{SEM}$, that cause variations to the CD distribution. In some embodiments, the CD distribution data includes the 8CD values of the contact holes, such as the first, second, and third set of 8CD values of the contact holes 515a-525a.

In some embodiments, the decomposer module 320 is implemented using an ICA method, which is discussed in detail at least with reference to FIG. 3. As described above, the ICA method may need N mixed signals to decompose them into N independent components. In some embodiments, since the LCDU data can include variations from three sources (e.g., $\delta CD_{MASK}$, $\delta CD_{RESIST}$, and $\delta CD_{SEM}$), three input signals 615, 620 and 625 are provided to the decomposer module 320. The first input signal 615 can include first set of 8CD values 515a, the second input signal 620 can include the second set of 8CD values 520a, and the third input signal 625 can include the third set of 8CD values 525a.

The decomposer module 320 may process the first, second, and third set of 8CD values of the contact holes 515a-525a (e.g., based on the ICA method as described above at least with reference to FIG. 3) to determine a mixing matrix 613, which is a set of coefficients of the linear mixtures represented by the first, second, and third set of 8CD values 515a-525a. In some embodiments, the mixing matrix 613 is similar to the mixing matrix (A) 313 shown in Eq. 3 or 11. After obtaining the mixing matrix 613, the decomposer module 320 obtains the error contributors as a function of the inverse 614 of mixing matrix 613 and the first, second, and third set of 8CD values 515a-525a as shown below. Note that the inverse 614 of the mixing matrix 613 can be a pseudo inverse in embodiments where the mixing matrix 613 is not a square matrix (e.g., number of sensors is greater than the number of sources that need to be decomposed).

$$\begin{bmatrix} \delta\text{CD}_{MASK} \\ \delta CD_{\text{RESIST}} \\ \delta\text{CD}_{SEM} \end{bmatrix} = \begin{bmatrix} a_{11} & a_{12} & a_{13} \\ a_{21} & a_{22} & a_{23} \\ a_{31} & a_{32} & a_{33} \end{bmatrix}^{+} \cdot \begin{bmatrix} \delta\text{CD}_{30\%} \\ \delta CD_{50\%} \\ \delta\text{CD}_{70\%} \end{bmatrix} \quad \dots (12)$$

Accordingly, the decomposer module 320 may determine the values of each of the error contributors based on Eq. 12. The decomposer module 320 may output three signals or datasets corresponding to the $\delta\text{CD}_{MASK}$, $\delta\text{CD}_{RESIST}$, and $\delta\text{CD}_{SEM}$ error contributions. For example, a first output signal or dataset may include values that correspond to $\delta\text{CD}_{MASK}$ error contribution 601, a second output signal or dataset may include values that correspond to $\delta\text{CD}_{RESIST}$ error contribution 602, and a third output signal or dataset may include values that correspond to $\delta\text{CD}_{SEM}$ error contribution 603. In FIG. 6, the error contributions are shown as a graph. In some embodiments, each output dataset may be a vector and the size the vector may be the same as the size of the vectors corresponding to the input mixed signals 615-625.

In some embodiments, the decomposer module 320 may determine a particular error contribution in terms of a single value instead of or in addition to as a vector. For example, the decomposer module 320 may determine a mean of the values in the first dataset 601 as the $\delta\text{CD}_{MASK}$ error contribution.

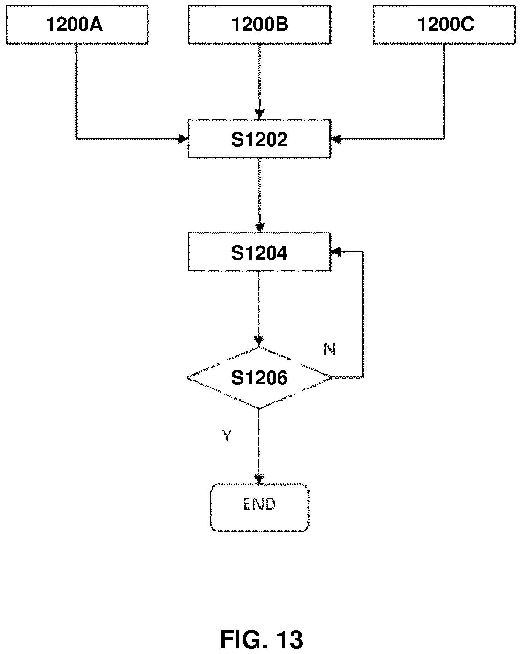

In some embodiments, the error contribution values 601-603 may be used for improving/optimizing various aspects of a patterning process such as source optimization or mask optimization or optimal proximity correction process. For example, based on the $\delta\text{CD}_{MASK}$ error contribution or the $\delta\text{CD}_{RESIST}$ error contribution, one or more parameters of a mask/patterning device or a lithographic apparatus used to print the pattern may be adjusted so that the pattern printed on the substrate satisfies a specified criterion. The parameters that may be adjusted may include adjustable parameters of the source, the patterning device, the projection optics, dose, focus, characteristics of the design layout/pattern, etc. Typically, optimizing or improving a patterning process includes adjusting one or more parameters until one or more cost functions associated with process is minimized or satisfies a specified criterion. Some examples of optimization are described at least with reference to FIGS. 13-16 below.

While the above decomposition process uses the CD distribution data such as the first, second, and third set of 8CD values 515a-525a as inputs 615-625, for determining the error contributors, in some embodiments, the decomposition process may also obtain the error contributors using LCDU data as inputs 615-625.

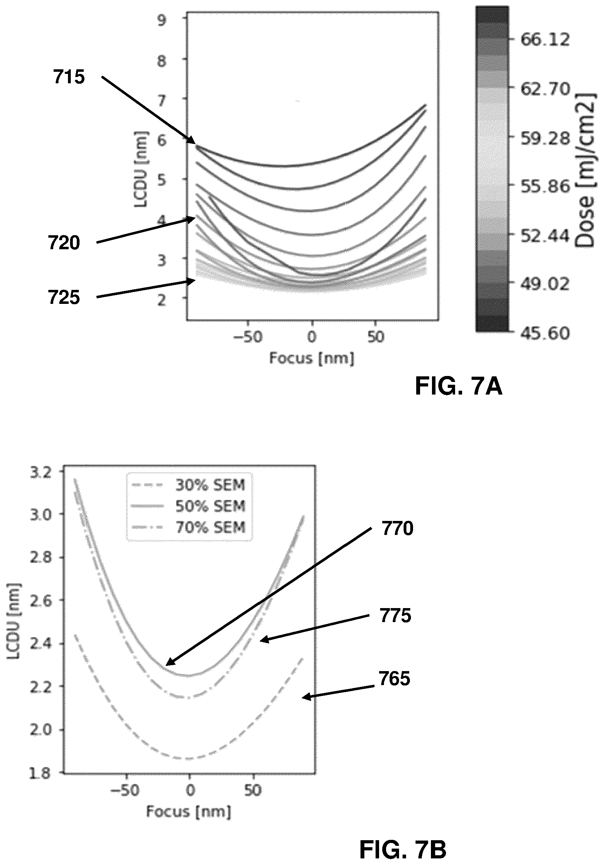

Figures 7A and 7B are graphs of LCDU data used for decomposing error contributors, according to an embodiment. In some embodiments, LCDU is the $3\sigma$ value of the CD distribution. In some embodiments, the LCDU values may be obtained from a focus exposure matrix (FEM) wafer through focus and dose values. Different parameters may be used as sensors to generate different mixed signals (e.g., that can be used as inputs to the decomposer module 320). For example, a dose level can be used as a sensor and different sets of LCDU data may be obtained for different dose levels as the input signals 615-625 (e.g., as shown in graph of FIG. 7A).

As illustrated in the graph of FIG. 7A, a first LCDU dataset 715 includes values corresponding to LCDU through focus for a first dose level (e.g., 45.60 mj/cm$^2$), a second LCDU dataset 720 includes values corresponding to LCDU through focus for a second dose level (e.g., 52.44 mj/cm$^2$), and a third LCDU dataset 725 includes values corresponding to LCDU through focus for a third dose level (e.g., 59.2 mj/cm$^2$).

Each LCDU dataset can be expressed as a linear mixture of the three error contributors as shown in the equation below (e.g., like the CD distribution linear mixtures of Eq. 8-10).

$$\text{LCDU}_1 = a11 * \text{LCDU}_{\text{MASK}} + a12 * \text{LCDU}_{\text{RESIST}} + a13 * \text{LCDU}_{\text{SEM}} \quad \dots (13)$$

$$\text{LCDU}_2 = a21 * \text{LCDU}_{\text{MASK}} + a22 * \text{LCDU}_{\text{RESIST}} + a23 * \text{LCDU}_{\text{SEM}} \quad \dots (14)$$

$$\text{LCDU}_3 = a31 * \text{LCDU}_{\text{MASK}} + a32 * \text{LCDU}_{\text{RESIST}} + a33 * \text{LCDU}_{\text{SEM}} \quad \dots (15)$$

The above LCDU datasets 715-725 may be provided as inputs 615-625, respectively, to the decomposer module 320. The decomposer module 320 processes the first, second, and third LCDU datasets (e.g., based on the ICA method as described above at least with reference to FIG. 3 and like the first, second, and third set of 8CD values 515a-525a described at least with reference to FIG. 6) to determine the error contributors, such as LCDU$_{\text{MASK}}$, LCDU$_{\text{RESIST}}$, and LCDU$_{\text{SEM}}$ (e.g., like the $\delta\text{CD}_{MASK}$ error contribution 601, $\delta\text{CD}_{RESIST}$ error contribution 602, and $\delta\text{CD}_{SEM}$ error contribution 603).

In another example, a white band value in a SEM image can be used as a sensor (e.g., as described at least with reference to FIG. 4) and different sets of LCDU data may be obtained for different threshold levels of the white band as the input signals 615-625 (e.g., as shown in graph of FIG. 7B). As illustrated in the graph of FIG. 7B, a first LCDU dataset 765 includes values corresponding to LCDU for a first threshold value of a white band (e.g., 30%), a second LCDU dataset 770 includes values corresponding to LCDU for a second threshold value of the white band (e.g., 50%), and a third LCDU dataset 775 includes values corresponding to LCDU for a third threshold value of the white band (e.g., 70%). Each LCDU dataset can be expressed as a linear mixture of the three error contributors as shown in Eqs. 13-15 and may be input to the decomposer module 320 as inputs 615-625 for obtaining the error contributions, such as $LCDU_{MASK}$, $LCDU_{RESIST}$, and $LCDU_{SEM}$.

In another example, a focus level can be used as a sensor and different sets of LCDU data may be obtained for different focus levels as the input signals 615-625. For example, a first LCDU dataset including LCDU values for multiple dose values at a first focus level, a second LCDU dataset includes LCDU values for multiple dose values at a second focus level, and a third LCDU dataset includes LCDU values for multiple dose values at a third focus level may be obtained.

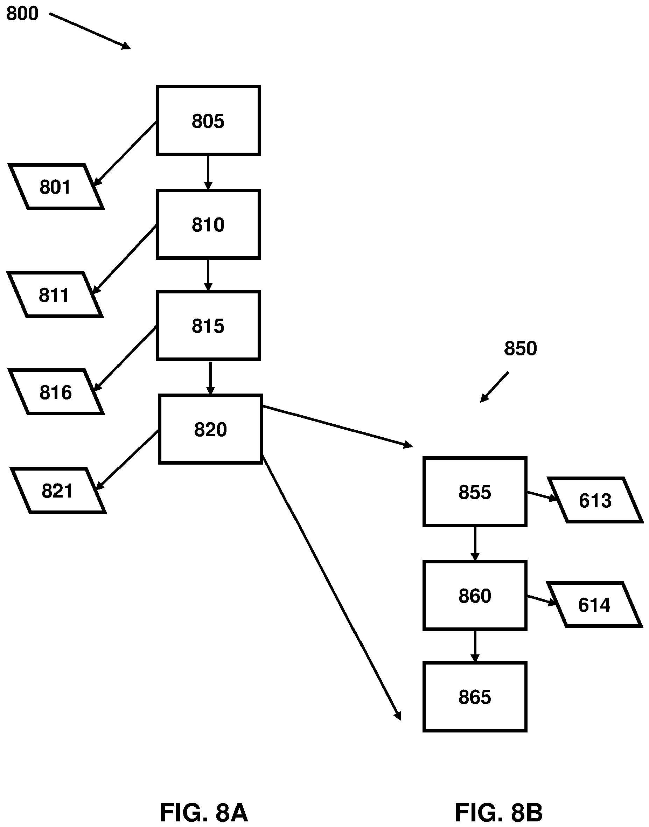

Figure 8A is a flow diagram of a process 800 for decomposing measurement values of a feature to derive error contributions from multiple sources to the feature, according to an embodiment. In some embodiments, a feature of a design pattern can be a contact hole, and a number of such contact holes may be printed on a substrate. At operation 805, an image 801 of a pattern printed on a substrate is obtained. In some embodiments, the image 801 can include the SEM image 405. In some embodiments, the image 801 is obtained using a tool such as a SEM. In some embodiments, multiple images of the pattern may be obtained.

At operation 810, multiple measurement values 811 of a feature of the pattern are obtained using the image 801. For example, the measurement values 811 may include CD distribution data (e.g., CD or 8CD values) or LCDU data of a number of contact holes for different sensor values. Different parameters can be used as sensors. For example, a threshold value associated with the image 801, such as a white band of the image 801 can be used as a sensor, and the measurement values 811 for different threshold values of the white band may include the first set of 8CD values 515a obtained at the first threshold value 421 (e.g., 30% of the white band), the second set of 8CD values 520a obtained at the second threshold value 422 (e.g., 50% of the white band), and a third set of 8CD values 525a obtained at the third threshold value 423 (e.g., 70% of the white band) as described at least with reference to FIGs. 4 and 5.

In another example, a dose level can be used a sensor and the measurement values 811 for different dose levels may include the first LCDU dataset 715 obtained for the first dose level, the second LCDU dataset 720 obtained for the second dose level, and the third LCDU dataset 725 obtained for the third dose level as described at least with reference to FIG. 7A.

At operation 815, each of the measurement values 811 is correlated to a linear mixture of the multiple error contributions to generate a number of linear mixtures 816. In some embodiments, the error contributions are derived using ICA method (e.g., as described at least with reference to FIGs. 3 and 6). Since there are three error contributors (e.g., $\delta CD_{MASK}$, $\delta CD_{RESIST}$, and $\delta CD_{SEM}$) at least three different linear mixtures 816 values may be needed for the decomposition process as the ICA method has a constraint that the number of mixed signals required as input has to be equal to the number of source components that need to be derived or decomposed from the input. Accordingly, three different linear mixtures 816 may have to be generated. In one example, the three different linear mixtures 816 may include the first, second, and third set of 8CD values 515a-525a, which may be represented using Eqs. 8-10. In another example, the three different linear mixtures 816 may include the first, second, and third LCDU datasets 715-725, which may be represented using Eqs. 13-15.

At operation 820, the error contributions 821 are derived from the linear mixtures 816. In some embodiments, the linear mixtures 816 are decomposed using the ICA method as described at least with reference to FIGS. 3 and 6. For example, the linear mixtures 816 including the first, second, and third set of 8CD values 515a-525a may be decomposed by providing them as inputs 615-625 to the decomposer module 320 (e.g., implemented using the ICA method) to derive the error contributors 821, such as the mask error contribution (e.g., $\delta CD_{MASK}$ error contribution 601), resist error contribution (e.g., $\delta CD_{RESIST}$ error contribution 602), and SEM error contribution (e.g., $\delta CD_{SEM}$ error contribution 603), as described at least with reference to FIG. 6. In another example, the linear mixtures 816 including the first, second, and third LCDU datasets 715-725 may be decomposed by providing them as inputs 615-625 to the decomposer module 320 to derive the error contributors 821, such as the mask error contribution (e.g., LCDUMASK), the resist error contribution (e.g., $LCDU_{RESIST}$), and the SEM error contribution (e.g., $LCDU_{SEM}$).

Figure 8B is a flow diagram of a process 850 for deriving error contributions from linear mixtures using ICA, according to an embodiment. In some embodiments, the process 850 is performed as part of operation 820 of process 800 of FIG. 8A. At operation 855, the linear mixtures 816 are processed using the ICA method to determine a mixing matrix, e.g., mixing matrix 613, which is a set of coefficients of the linear mixtures 816 represented by the first, second, and third set of 8CD values 515a-525a. The mixing matrix 613 may be expressed as shown in Eq. 3 or 11. In some embodiments, the mixing matrix 613 is determined as described at least with reference to FIGs. 3 and 6.

At operation 860, an inverse of the mixing matrix A 613 is determined, e.g., as shown in Eq. 12, to obtain an unmixing matrix 614.

At operation 865, the error contributions 821 are derived from the linear mixtures 816 using the unmixing matrix 614, e.g., as shown in Eq. 12.

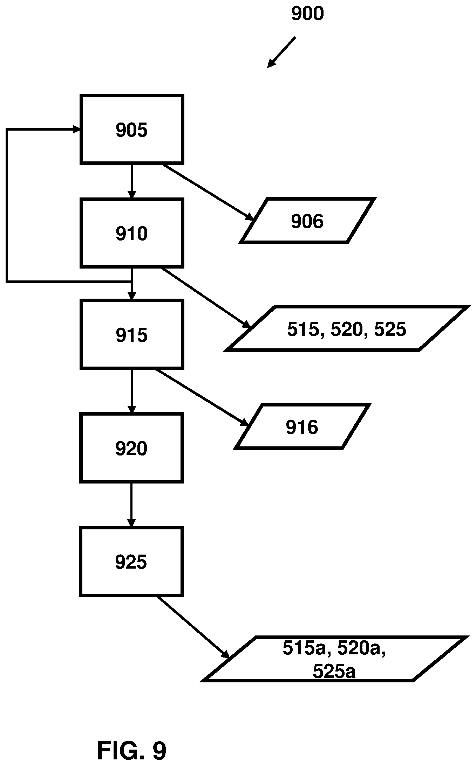

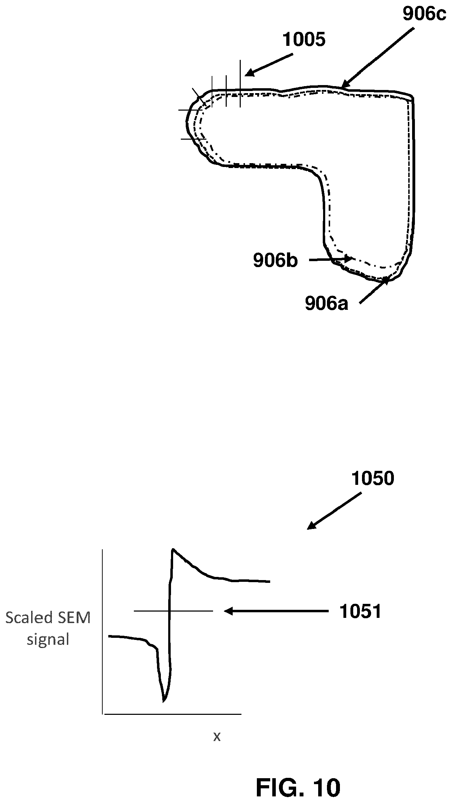

Figure 9 is a flow diagram of a process 900 for obtaining measurement values for the decomposition process of FIG. 8, according to an embodiment. In some embodiments, the process 900 may be executed as part of operation 810 of FIG. 8A. At operation 905, a contour 906 of a feature of the pattern is obtained. For example, the contour 906 can include the contour of the contact holes in the SEM image 405. In some embodiments, any of a known number of methods may be used to determine the contour of the contact hole. For example, a thresholding technique can be applied to a SEM image to obtain the contour of the feature. In some embodiments, the thresholding technique can determine the contour based on the change in pixel values of the greyscale SEM image, e.g., pixels having values satisfying a specified threshold (e.g., of a white band value) can form a contour of the feature. Figure 10 shows a contour of the feature obtained using one such technique.

In some embodiments, due to the presence of a noise (e.g., error contributions from multiple sources such as mask, resist and SEM), the contour 906 is subject to distortions giving rise to different contour heights, such as 906a, 906b and 906c. In some embodiments, the distorted contours 906a-906c may be identified by thresholding the SEM image to different threshold values and the CD values of the contour 906 can be obtained for different thresholds. For example, contour 906a may be identified be thresholding the SEM image 405 to a first threshold value (e.g., 30% of the white band value as described at least with reference to FIGs. 4 and 5) and contour 906b may be identified be thresholding the SEM image 405 to a second threshold value (e.g., 50% of the white band value as described at least with reference to FIGs. 4 and 5).

At operation 910, CD values are obtained for different threshold values. For example, a specified threshold value 1051 may be the first threshold value 421 (e.g., 30% of the white band value) as shown in graph 415 of FIG. 4, and a CD value may correspond to the first threshold value 421.

A CD value may be obtained using any of a number of methods. Figure 10 shows a method of obtaining the CD value of a contour, according to an embodiment. In some embodiments, the CD value of the contour 906 is measured by defining cutlines (e.g., measurement points associated with the contour 906). For measurements, different cut-lines are defined such that each cut-line (e.g., cutline 1005) pass through the contour 906 in a direction perpendicular to contour 906. Such cutlines can be applied to measure any contour having any arbitrary shape. Each cutline can be extended to intersect the contour 906, which is referred to as a measurement point. A one-dimensional (1D) image (e.g., SEM signal such as pixel value vs. x, which is a coordinate of a particular pixel from a particular reference point) is generated from the cutline 1006 as shown in graph 1050. A specified threshold 1051 may be applied to the 1D-image to obtain the disposition dx of the cutline 1005, which provides the CD value of the contour 906 for the cutline (e.g., the measurement point) for the specified threshold 1051. In some embodiments, the 1-D image is subjected to different thresholds to get the CD values corresponding to different thresholds. For example, if the specified threshold value 1051 is the first threshold value 421 (e.g., 30% of the white band value), the disposition dx may be a CD value corresponding to the first threshold value 421 as shown in graph 415. In another example, if the specified threshold value 1051 is the second threshold value 422 (e.g., 50% of the white band value), the disposition dx may be a CD value corresponding to the second threshold value 422 as shown in graph 415. In another example, if the specified threshold value 1051 is the third threshold value 423 (e.g., 70% of the white band value), the disposition dx may be a CD value corresponding to the third threshold value 423 as shown in graph 415.

At the end of operation 910, different CD values (e.g., three different CD values) corresponding to different thresholds (e.g., three different thresholds 420-422) may be obtained for a particular cut-line (or measurement point). In some embodiments, the operations 905 and 910 are repeated for a finite number of iterations (e.g., user defined number) to obtain the CD values for each threshold for the finite number of measurement points (e.g., cutlines). The measurement points can be in on the same contact hole or different contact holes. At the conclusion of the finite number of iterations of 905 and 910, different sets of CD values are created. For example, the first set of CD values 515 corresponding to the first threshold value 421 of 30% as shown in FIG. 5, the second set of CD values 520 corresponding to the second threshold value 422 of 50%, and the third set of CD values 525 corresponding to the third threshold value 423 of 70% having CD values for the various measurement points are created.

At operation 915, a mean value 916 of the CD values is determined. The CD values may include those obtained in operation 910, such as the first, second and third set of CD values 515-525.

At operation 920, the mean value 916 may be shifted to a specified value (e.g., "0"). In some embodiments, shifting the mean value 916 to the specified value may include subtracting a difference between the mean value 916 and the specified value from each of the CD values.

At operation 925, 8CD value is obtained for each of the CD values in the first, second and third set of CD values 515-525. For example, the first set of 8CD values 515a of FIG. 5 that corresponds to the first threshold value 421 is obtained from the first set of CD values 515, the second set of 8CD values 520a that corresponds to the first threshold value 421 is obtained from the second set of CD values 520, and the third set of 8CD values 525a that corresponds to the first threshold value 421 is obtained from the third set of CD values 520.

In some embodiments, after obtaining the first, second and third sets of 8CD values 515a-525a, the process 900 may return to operation 815 of process 800.

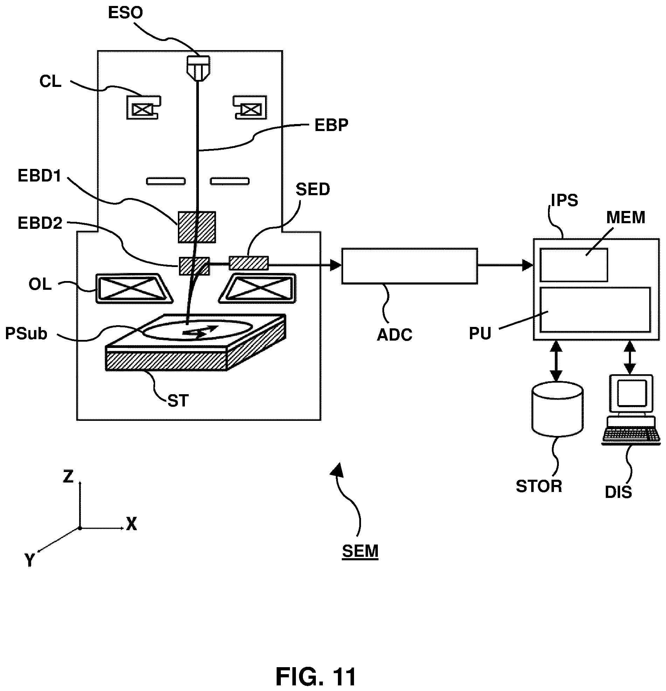

Figure 11 depicts an embodiment of a scanning electron microscope (SEM) tool, consistent with various embodiments. In some embodiments, an inspection apparatus may be a SEM that yields an image of a structure (e.g., some or all the structure of a device) exposed or transferred on the substrate. A primary electron beam EBP emitted from an electron source ESO is converged by condenser lens CL and then passes through a beam deflector EBD1, an E x B deflector EBD2, and an objective lens OL to irradiate a substrate PSub on a substrate table ST at a focus.

When the substrate PSub is irradiated with electron beam EBP, secondary electrons are generated from the substrate PSub. The secondary electrons are deflected by the E x B deflector EBD2 and detected by a secondary electron detector SED. A two-dimensional electron beam image can be obtained by detecting the electrons generated from the sample in synchronization with, e.g., two dimensional scanning of the electron beam by beam deflector EBD1 or with repetitive scanning of electron beam EBP by beam deflector EBD1 in an X or Y direction, together with continuous movement of the substrate PSub by the substrate table ST in the other of the X or Y direction.

A signal detected by secondary electron detector SED is converted to a digital signal by an analog/digital (A/D) converter ADC, and the digital signal is sent to an image processing system IPU. In an embodiment, the image processing system IPU may have memory MEM to store all or part of digital images for processing by a processing unit PU. The processing unit PU (e.g., specially designed hardware or a combination of hardware and software) is configured to convert or process the digital images into datasets representative of the digital images. Further, image processing system IPU may have a storage medium STOR configured to store the digital images and corresponding datasets in a reference database. A display device DIS may be connected with the image processing system IPU, so that an operator can conduct necessary operation of the equipment with the help of a graphical user interface.

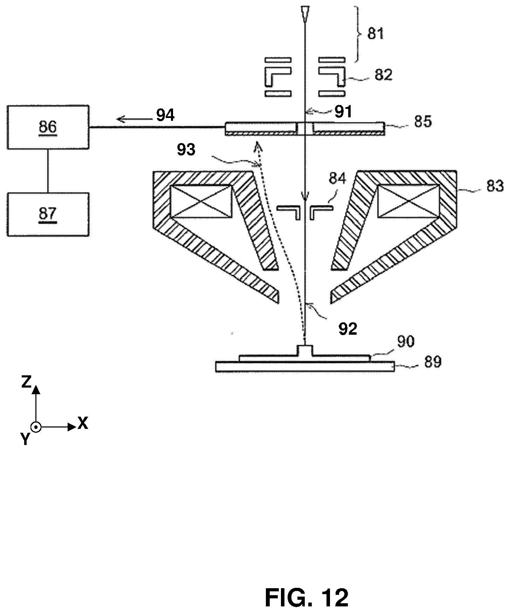

Figure 12 schematically illustrates a further embodiment of an inspection apparatus. The system is used to inspect a sample 90 (such as a substrate) on a sample stage 89 and comprises a charged particle beam generator 81, a condenser lens module 82, a probe forming objective lens module 83, a charged particle beam deflection module 84, a secondary charged particle detector module 85, and an image forming module 86.

The charged particle beam generator 81 generates a primary charged particle beam 91. The condenser lens module 82 condenses the generated primary charged particle beam 91. The probe forming objective lens module 83 focuses the condensed primary charged particle beam into a charged particle beam probe 92. The charged particle beam deflection module 84 scans the formed charged particle beam probe 92 across the surface of an area of interest on the sample 90 secured on the sample stage 89. In an embodiment, the charged particle beam generator 81, the condenser lens module 82 and the probe forming objective lens module 83, or their equivalent designs, alternatives or any combination thereof, together form a charged particle beam probe generator which generates the scanning charged particle beam probe 92.

The secondary charged particle detector module 85 detects secondary charged particles 93 emitted from the sample surface (maybe also along with other reflected or scattered charged particles from the sample surface) upon being bombarded by the charged particle beam probe 92 to generate a secondary charged particle detection signal 94. The image forming module 86 (e.g., a computing device) is coupled with the secondary charged particle detector module 85 to receive the secondary charged particle detection signal 94 from the secondary charged particle detector module 85 and accordingly forming at least one scanned image. In an embodiment, the secondary charged particle detector module 85 and image forming module 86, or their equivalent designs, alternatives or any combination thereof, together form an image forming apparatus which forms a scanned image from detected secondary charged particles emitted from sample 90 being bombarded by the charged particle beam probe 92.

As noted above, SEM images may be processed to extract contours that describe the edges of objects, representing device structures, in the image. These contours are then quantified via metrics, such as CD. Thus, typically, the images of device structures are compared and quantified via simplistic metrics, such as an edge-to-edge distance (CD) or simple pixel differences between images. Typical contour models that detect the edges of the objects in an image in order to measure CD use image gradients. Indeed, those models rely on strong image gradients. But, in practice, the image typically is noisy and has discontinuous boundaries. Techniques, such as smoothing, adaptive thresholding, edge-detection, erosion, and dilation, may be used to process the results of the image gradient contour models to address noisy and discontinuous images, but will ultimately result in a low-resolution quantification of a high-resolution image. Thus, in most instances, mathematical manipulation of images of device structures to reduce noise and automate edge detection results in loss of resolution of the image, thereby resulting in loss of information. Consequently, the result is a low-resolution quantification that amounts to a simplistic representation of a complicated, high-resolution structure.

So, it is desirable to have a mathematical representation of the structures (e.g., circuit features, alignment mark or metrology target portions (e.g., grating features), etc.) produced or expected to be produced using a patterning process, whether, e.g., the structures are in a latent resist image, in a developed resist image or transferred to a layer on the substrate, e.g., by etching, that can preserve the resolution and yet describe the general shape of the structures. In the context of lithography or other pattering processes, the structure may be a device or a portion thereof that is being manufactured and the images may be SEM images of the structure. In some instances, the structure may be a feature of semiconductor device, e.g., integrated circuit. In some instances, the structure may be an alignment mark, or a portion thereof (e.g., a grating of the alignment mark), that is used in an alignment measurement process to determine alignment of an object (e.g., a substrate) with another object (e.g., a patterning device) or a metrology target, or a portion thereof (e.g., a grating of the metrology target), that is used to measure a parameter (e.g., overlay, focus, dose, etc.) of the patterning process. In an embodiment, the metrology target is a diffractive grating used to measure, e.g., overlay.

In an embodiment, the measurement data (e.g., stochastic variations) related to the printed pattern, determined according to the method of Figure 3, may be employed in optimization of patterning process or adjusting parameters of the patterning process. As an example, OPC addresses the fact that the final size and placement of an image of the design layout projected on the substrate will not be identical to, or simply depend only on the size and placement of the design layout on the patterning device. It is noted that the terms "mask", "reticle", "patterning device" are utilized interchangeably herein. Also, person skilled in the art will recognize that, especially in the context of lithography simulation/optimization, the term "mask"/"patterning device" and "design layout" can be used interchangeably, as in lithography simulation/optimization, a physical patterning device is not necessarily used but a design layout can be used to represent a physical patterning device. For the small feature sizes and high feature densities present on some design layout, the position of a particular edge of a given feature will be influenced to a certain extent by the presence or absence of other adjacent features. These proximity effects arise from minute amounts of radiation coupled from one feature to another or non-geometrical optical effects such as diffraction and interference. Similarly, proximity effects may arise from diffusion and other chemical effects during post-exposure bake (PEB), resist development, and etching that generally follow lithography.

In order to ensure that the projected image of the design layout is in accordance with requirements of a given target circuit design, proximity effects need to be predicted and compensated for, using sophisticated numerical models, corrections or pre-distortions of the design layout. The article "Full-Chip Lithography Simulation and Design Analysis - How OPC Is Changing IC Design", C. Spence, Proc. SPIE, Vol. 5751, pp 1-14 (2005) provides an overview of current "model-based" optical proximity correction processes. In a typical high-end design almost every feature of the design layout has some modification in order to achieve high fidelity of the projected image to the target design. These modifications may include shifting or biasing of edge positions or line widths as well as application of "assist" features that are intended to assist projection of other features.

Application of model-based OPC to a target design involves good process models and considerable computational resources, given the many millions of features typically present in a chip design. However, applying OPC is generally not an "exact science", but an empirical, iterative process that does not always compensate for all possible proximity effect. Therefore, effect of OPC, e.g., design layouts after application of OPC and any other RET, need to be verified by design inspection, i.e. intensive full-chip simulation using calibrated numerical process models, in order to minimize the possibility of design flaws being built into the patterning device pattern. This is driven by the enormous cost of making high-end patterning devices, which run in the multi-million dollar range, as well as by the impact on turn-around time by reworking or repairing actual patterning devices once they have been manufactured.

Both OPC and full-chip RET verification may be based on numerical modeling systems and methods as described, for example in, U.S. Patent App. No. 10/815 ,573 and an article titled "Optimized Hardware and Software For Fast, Full Chip Simulation", by Y. Cao et al., Proc. SPIE, Vol. 5754, 405 (2005).

One RET is related to adjustment of the global bias of the design layout. The global bias is the difference between the patterns in the design layout and the patterns intended to print on the substrate. For example, a circular pattern of 25 nm diameter may be printed on the substrate by a 50 nm diameter pattern in the design layout or by a 20 nm diameter pattern in the design layout but with high dose.

In addition to optimization to design layouts or patterning devices (e.g., OPC), the illumination source can also be optimized, either jointly with patterning device optimization or separately, in an effort to improve the overall lithography fidelity. The terms "illumination source" and "source" are used interchangeably in this document. Since the 1990s, many off-axis illumination sources, such as annular, quadrupole, and dipole, have been introduced, and have provided more freedom for OPC design, thereby improving the imaging results, As is known, off-axis illumination is a proven way to resolve fine structures (i.e., target features) contained in the patterning device. However, when compared to a traditional illumination source, an off-axis illumination source usually provides less radiation intensity for the aerial image (AI). Thus, it becomes desirable to attempt to optimize the illumination source to achieve the optimal balance between finer resolution and reduced radiation intensity.

Numerous illumination source optimization approaches can be found, for example, in an article by Rosenbluth et al., titled "Optimum Mask and Source Patterns to Print A Given Shape", Journal of Microlithography, Microfabrication, Microsystems 1(1), pp.13-20, (2002). The source is partitioned into several regions, each of which corresponds to a certain region of the pupil spectrum. Then, the source distribution is assumed to be uniform in each source region and the brightness of each region is optimized for process window. However, such an assumption that the source distribution is uniform in each source region is not always valid, and as a result the effectiveness of this approach suffers. In another example set forth in an article by Granik, titled "Source Optimization for Image Fidelity and Throughput", Journal of Microlithography, Microfabrication, Microsystems 3(4), pp.509-522, (2004), several existing source optimization approaches are overviewed and a method based on illuminator pixels is proposed that converts the source optimization problem into a series of non-negative least square optimizations. Though these methods have demonstrated some successes, they typically require multiple complicated iterations to converge. In addition, it may be difficult to determine the appropriate/optimal values for some extra parameters, such as $\gamma$ in Granik's method, which dictates the trade-off between optimizing the source for substrate image fidelity and the smoothness requirement of the source.

For low $k_1$ photolithography, optimization of both the source and patterning device is useful to ensure a viable process window for projection of critical circuit patterns. Some algorithms (e.g. Socha et. al. Proc. SPIE vol. 5853, 2005, p.180) discretize illumination into independent source points and mask into diffraction orders in the spatial frequency domain, and separately formulate a cost function (which is defined as a function of selected design variables) based on process window metrics such as exposure latitude which could be predicted by optical imaging models from source point intensities and patterning device diffraction orders. The term "design variables" as used herein comprises a set of parameters of a lithographic projection apparatus or a lithographic process, for example, parameters a user of the lithographic projection apparatus can adjust, or image characteristics a user can adjust by adjusting those parameters. It should be appreciated that any characteristics of a lithographic projection process, including those of the source, the patterning device, the projection optics, or resist characteristics can be among the design variables in the optimization. The cost function is often a non-linear function of the design variables. Then standard optimization techniques are used to minimize the cost function.

Relatedly, the pressure of ever decreasing design rules have driven semiconductor chipmakers to move deeper into the low $k_1$ lithography era with existing 193 nm ArF lithography. Lithography towards lower $k_1$ puts heavy demands on RET, exposure tools, and the need for litho-friendly design. 1.35 ArF hyper numerical aperture (NA) exposure tools may be used in the future. To help ensure that circuit design can be produced on to the substrate with workable process window, source-patterning device optimization (referred to herein as source-mask optimization or SMO) is becoming a significant RET for 2x nm node.

A source and patterning device (design layout) optimization method and system that allows for simultaneous optimization of the source and patterning device using a cost function without constraints and within a practicable amount of time is described in a commonly assigned International Patent Application No. PCT/US2009/065359, filed on November 20, 2009, and published as WO2010/059954, titled "Fast Freeform Source and Mask Co-Optimization Method", which is hereby incorporated by reference in its entirety.

Another source and mask optimization method and system that involves optimizing the source by adjusting pixels of the source is described in a commonly assigned U.S. Patent Application No. 12/813456, filed on June 10, 2010, and published as U.S. Patent Application Publication No. 2010/0315614, titled "Source-Mask Optimization in Lithographic Apparatus", which is hereby incorporated by reference in its entirety.

In a lithographic projection apparatus, as an example, a cost function is expressed as

$$CF(z_1, z_2, \ldots, z_N) = \sum_{p=1}^{P} w_p f_p^2(z_1, z_2, \ldots, z_N) \qquad \text{(Eq. 1)}$$

wherein $(z_1, z_2, \ldots, z_N)$ are $N$ design variables or values thereof. $f_p(z_1, z_2, \ldots, z_N)$ can be a function of the design variables $(z_1, z_2, \ldots, z_N)$ such as a difference between an actual value and an intended value of a characteristic at an evaluation point for a set of values of the design variables of $(z_1, z_2, \ldots, z_N)$. $w_p$ is a weight constant associated with $f_p(z_1, z_2, \ldots, z_N)$. An evaluation point or pattern more critical than others can be assigned a higher $w_p$ value. Patterns or evaluation points with larger number of occurrences may be assigned a higher $w_p$ value, too. Examples of the evaluation points can be any physical point or pattern on the substrate, any point on a virtual design layout, or resist image, or aerial image, or a combination thereof. $f_p(z_1, z_2, \ldots, z_N)$ can also be a function of one or more stochastic effects such as the LWR, which are functions of the design variables $(z_1, z_2, \ldots, z_N)$. The cost function may represent any suitable characteristics of the lithographic projection apparatus or the substrate, for instance, failure rate of a feature, focus, CD, image shift, image distortion, image rotation, stochastic effects, throughput, CDU, or a combination thereof. CDU is local CD variation (e.g., three times of the standard deviation of the local CD distribution). CDU may be interchangeably referred to as LCDU. In one embodiment, the cost function represents (i.e., is a function of) CDU, throughput, and the stochastic effects. In one embodiment, the cost function represents (i.e., is a function of) EPE, throughput, and the stochastic effects. In one embodiment, the design variables $(z_1, z_2, \ldots, z_N)$ comprise dose, global bias of the patterning device, shape of illumination from the source, or a combination thereof. Since it is the resist image that often dictates the circuit pattern on a substrate, the cost function often includes functions that represent some characteristics of the resist image. For example, $f_p(z_1, z_2, \ldots, z_N)$ of such an evaluation point can be simply a distance between a point in the resist image to an intended position of that point (i.e., edge placement error $EPE_p(z_1,z_2,...,z_N)$). The design variables can be any adjustable parameters such as adjustable parameters of the source, the patterning device, the projection optics, dose, focus, etc. The projection optics may include components collectively called as "wavefront manipulator" that can be used to adjust shapes of a wavefront and intensity distribution or phase shift of the irradiation beam. The projection optics preferably can adjust a wavefront and intensity distribution at any location along an optical path of the lithographic projection apparatus, such as before the patterning device, near a pupil plane, near an image plane, near a focal plane. The projection optics can be used to correct or compensate for certain distortions of the wavefront and intensity distribution caused by, for example, the source, the patterning device, temperature variation in the lithographic projection apparatus, thermal expansion of components of the lithographic projection apparatus. Adjusting the wavefront and intensity distribution can change values of the evaluation points and the cost function. Such changes can be simulated from a model or actually measured. Of course, $CF(z_1,z_2,...,z_N)$ is not limited the form in Eq. 1. $CF(z_1, z_2,...,z_N)$ can be in any other suitable form.

It should be noted that the normal weighted root mean square (RMS) of $f_p(z_1,z_2,...,z_N)$ is defined as

$$\sqrt{\frac{1}{P}\sum_{p=1}^{P} w_p f_p^2 (z_1, z_2, \ldots, z_N)} \,,$$

therefore, minimizing the weighted RMS of $f_p(z_1,z_2,...,z_N)$ is equivalent to minimizing

$$CF(z_1, z_2, \ldots, z_N) = \sum_{p=1}^{P} w_p f_p^2 (z_1, z_2, \ldots, z_N) \,,$$

the cost function defined in Eq. 1. Thus the weighted RMS of $f_p(z_1,z_2,...,z_N)$ and Eq. 1 may be utilized interchangeably for notational simplicity herein.

Further, if considering maximizing the PW (Process Window), one can consider the same physical location from different PW conditions as different evaluation points in the cost function in (Eq.1). For example, if considering $N$ PW conditions, then one can categorize the evaluation points according to their PW conditions and write the cost functions as:

$$CF(z_1, z_2, \ldots, z_N) = \sum_{p=1}^{P} w_p f_p^2 (z_1, z_2, \ldots, z_N) = \sum_{u=1}^{U} \sum_{p_u=1}^{P_u} w_{p_u} f_{p_u}^2 (z_1, z_2, \ldots, z) \ \text{(Eq. 1')}$$

Where $f_{p_u}(z_1,z_2,..., z_N)$ is the value of $f_p(z_1,z_2,...,z_N)$ under the u-th PW condition $u = 1,...,U$. When $f_p(z_1,z_2,...,z_N)$ is the EPE, then minimizing the above cost function is equivalent to minimizing the edge shift under various PW conditions, thus this leads to maximizing the PW. In particular, if the PW also consists of different mask bias, then minimizing the above cost function also includes the minimization of MEEF (Mask Error Enhancement Factor), which is defined as the ratio between the substrate EPE and the induced mask edge bias.

The design variables may have constraints, which can be expressed as $(z_1, z_2,...,z_N) \in Z$, where Z is a set of possible values of the design variables. One possible constraint on the design variables may be imposed by yield or a desired throughput of the lithographic projection apparatus. The desired yield or throughput may limit the dose and thus has implications for the stochastic effects (e.g., imposing a lower bound on the stochastic effects). Higher throughput generally leads to lower dose, shorter longer exposure time and greater stochastic effects. Higher yield generally leads to a restricted design which may be sensitive to stochastic risk. Consideration of substrate throughput, yield and minimization of the stochastic effects may constrain the possible values of the design variables because the stochastic effects are function of the design variables. Without such a constraint imposed by the desired throughput, the optimization may yield a set of values of the design variables that are unrealistic. For example, if the dose is among the design variables, without such a constraint, the optimization may yield a dose value that makes the throughput economically impossible. However, the usefulness of constraints should not be interpreted as a necessity. The throughput may be affected by the failure rate based adjustment to parameters of the patterning process. It is desirable to have lower failure rate of the feature while maintaining a high throughput. Throughput may also be affected by the resist chemistry. Slower resist (e.g., a resist that requires higher amount of light to be properly exposed) leads to lower throughput. Thus, based on the optimization process involving failure rate of a feature due to resist chemistry or fluctuations, and dose requirements for higher throughput, appropriate parameters of the patterning process may be determined.

The optimization process therefore is to find a set of values of the design variables, under the constraints $(z_1, z_2,...,z_N) \in Z$, that minimize the cost function, i.e., to find

$$(\tilde{z}_1, \tilde{z}_2, \ldots \tilde{z}_N) = \underset{(z_1, z_2, \ldots, z_N) \in Z}{\arg\min} \, CF(z_1, z_2, \ldots, z_N) = \underset{(z_1, z_2, \ldots, z_N) \in Z}{\arg\min} \sum_{p=1}^{P} w_p f_p^2(z_1, z_2, \ldots, z_N) \qquad \text{(Eq. 2)}$$

A general method of optimizing the lithography projection apparatus, according to an embodiment, is illustrated in Figure 13. This method comprises a step S1202 of defining a multi-variable cost function of a plurality of design variables. The design variables may comprise any suitable combination selected from characteristics of the illumination source (1200A) (e.g., pupil fill ratio, namely percentage of radiation of the source that passes through a pupil or aperture), characteristics of the projection optics (1200B) and characteristics of the design layout (1200C). For example, the design variables may include characteristics of the illumination source (1200A) and characteristics of the design layout (1200C) (e.g., global bias) but not characteristics of the projection optics (1200B), which leads to an SMO. Alternatively, the design variables may include characteristics of the illumination source (1200A), characteristics of the projection optics (1200B) and characteristics of the design layout (1200C), which leads to a source-mask-lens optimization (SMLO). In step S1204, the design variables are simultaneously adjusted so that the cost function is moved towards convergence. In step S1206, it is determined whether a predefined termination condition is satisfied. The predetermined termination condition may include various possibilities, i.e. the cost function may be minimized or maximized, as required by the numerical technique used, the value of the cost function has been equal to a threshold value or has crossed the threshold value, the value of the cost function has reached within a preset error limit, or a preset number of iteration is reached. If either of the conditions in step S1206 is satisfied, the method ends. If none of the conditions in step S1206 is satisfied, the step S1204 and S1206 are iteratively repeated until a desired result is obtained. The optimization does not necessarily lead to a single set of values for the design variables because there may be physical restraints caused by factors such as the failure rates, the pupil fill factor, the resist chemistry, the throughput, etc. The optimization may provide multiple sets of values for the design variables and associated performance characteristics (e.g., the throughput) and allows a user of the lithographic apparatus to pick one or more sets.

In a lithographic projection apparatus, the source, patterning device and projection optics can be optimized alternatively (referred to as Alternative Optimization) or optimized simultaneously (referred to as Simultaneous Optimization). The terms "simultaneous", "simultaneously", "joint" and "jointly" as used herein mean that the design variables of the characteristics of the source, patterning device, projection optics or any other design variables, are allowed to change at the same time. The term "alternative" and "alternatively" as used herein mean that not all of the design variables are allowed to change at the same time.

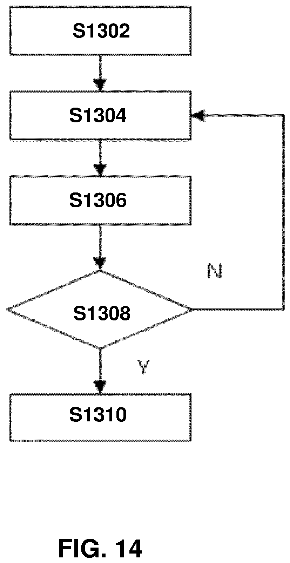

In Figure 14, the optimization of all the design variables is executed simultaneously. Such flow may be called the simultaneous flow or co-optimization flow. Alternatively, the optimization of all the design variables is executed alternatively, as illustrated in Figure 14. In this flow, in each step, some design variables are fixed while the other design variables are optimized to minimize the cost function; then in the next step, a different set of variables are fixed while the others are optimized to minimize the cost function. These steps are executed alternatively until convergence or certain terminating conditions are met.

As shown in the non-limiting example flowchart of Figure 14, first, a design layout (step S1302) is obtained, then a step of source optimization is executed in step S1304, where all the design variables of the illumination source are optimized (SO) to minimize the cost function while all the other design variables are fixed. Then in the next step S1306, a mask optimization (MO) is performed, where all the design variables of the patterning device are optimized to minimize the cost function while all the other design variables are fixed. These two steps are executed alternatively, until certain terminating conditions are met in step S1308. Various termination conditions can be used, such as, the value of the cost function becomes equal to a threshold value, the value of the cost function crosses the threshold value, the value of the cost function reaches within a preset error limit, or a preset number of iteration is reached, etc. Note that SO-MO-Alternative-Optimization is used as an example for the alternative flow. The alternative flow can take many different forms, such as SO-LO-MO-Alternative-Optimization, where SO, LO (Lens Optimization) is executed, and MO alternatively and iteratively; or first SMO can be executed once, then execute LO and MO alternatively and iteratively; and so on. Finally, the output of the optimization result is obtained in step S1310, and the process stops.

The pattern selection algorithm, as discussed before, may be integrated with the simultaneous or alternative optimization. For example, when an alternative optimization is adopted, first a full-chip SO can be performed, the 'hot spots' or 'warm spots' are identified, then an MO is performed. In view of the present disclosure numerous permutations and combinations of sub-optimizations are possible in order to achieve the desired optimization results.

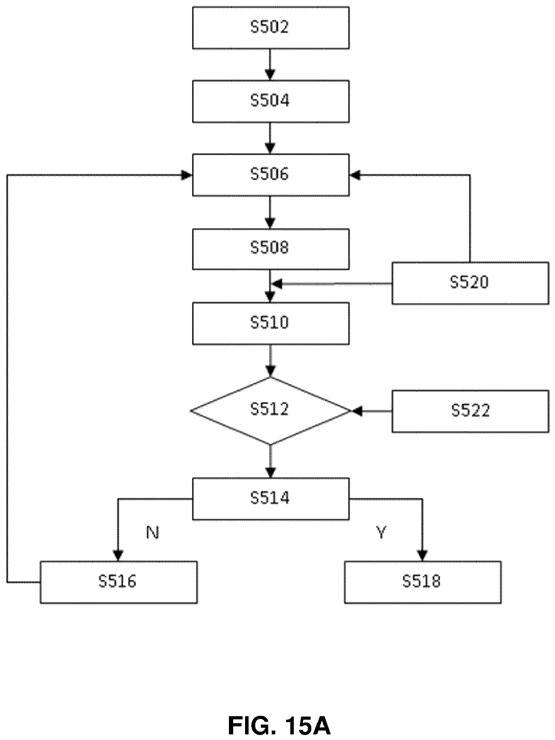

Figure 15A shows one exemplary method of optimization, where a cost function is minimized. In step S502, initial values of design variables are obtained, including their tuning ranges, if any. In step S504, the multi-variable cost function is set up. In step S506, the cost function is expanded within a small enough neighborhood around the starting point value of the design variables for the first iterative step (i=0). In step S508, standard multi-variable optimization techniques are applied to minimize the cost function. Note that the optimization problem can apply constraints, such as tuning ranges, during the optimization process in S508 or at a later stage in the optimization process. Step S520 indicates that each iteration is done for the given test patterns (also known as "gauges") for the identified evaluation points that have been selected to optimize the lithographic process. In step S510, a lithographic response is predicted. In step S512, the result of step S510 is compared with a desired or ideal lithographic response value obtained in step S522. If the termination condition is satisfied in step S514, i.e. the optimization generates a lithographic response value sufficiently close to the desired value, and then the final value of the design variables is outputted in step S518. The output step may also include outputting other functions using the final values of the design variables, such as outputting a wavefront aberration-adjusted map at the pupil plane (or other planes), an optimized source map, and optimized design layout etc. If the termination condition is not satisfied, then in step S516, the values of the design variables is updated with the result of the i-th iteration, and the process goes back to step S506. The process of Figure 15A is elaborated in details below.

In an exemplary optimization process, no relationship between the design variables $(z_1, z_2,...,z_N)$ and $f_p(z_1, z_2,...,z_N)$ is assumed or approximated, except that $f_p(z_1, z_2,...,z_N)$ is sufficiently smooth (e.g. first order derivatives

$$\frac{\partial f_p(z_1, z_2, \ldots, z_N)}{\partial z_n},$$

($n = 1,2,... N$) exist), which is generally valid in a lithographic projection apparatus. An algorithm, such as the Gauss-Newton algorithm, the Levenberg-Marquardt algorithm, the gradient descent algorithm, simulated annealing, the genetic algorithm, can be applied to find $(\tilde{z}_1, \tilde{z}_2,... \tilde{z}_N)$.

Here, the Gauss-Newton algorithm is used as an example. The Gauss-Newton algorithm is an iterative method applicable to a general non-linear multi-variable optimization problem. In the $i$-th iteration wherein the design variables $(z_1, z_2,...,z_N)$ take values of $(z_{1i}, z_{2i},...,z_{Ni})$, the Gauss-Newton algorithm linearizes $f_p(z_1, z_2,... ,z_N)$ in the vicinity of $(z_{1i}, z_{2i},...,z_{Ni})$, and then calculates values $(z_{1(i+1)}, z_{2(i+1)},...,z_{N(i+1)})$ in the vicinity of $(z_{1i}, z_{2i},...,z_{Ni})$ that give a minimum of $CF(z_1, z_2,...,z_N)$. The design variables $(z_1, z_2,...,z_N)$ take the values of $(z_{1(i+1)}, z_{2(i+1)},...,z_{N(i+1)})$ in the $(i+1)$-th iteration. This iteration continues until convergence (i.e. $CF(z_1, z_2,...,z_N)$ does not reduce any further) or a preset number of iterations is reached.

Specifically, in the i-th iteration, in the vicinity of $(z_{1i}, z_{2i},...,z_{Ni})$,

$$f_p(z_1, z_2, \ldots, z_N) \approx f_p(z_{1i}, z_{2i}, \ldots, z_{Ni}) + \sum_{n=1}^{N} \left. \frac{\partial f_p(z_1, z_2, \ldots, z_N)}{\partial z_n} \right|_{z_1=z_{1i}, z_2=z_{2i}, \ldots, z_N=z_{Ni,}} (z_n - z_{ni}) \quad \text{(Eq. 3)}$$

Under the approximation of Eq. 3, the cost function becomes:

$$CF(z_1, z_2, \ldots, z_N) = \sum_{p=1}^{P} w_p f_p^2(z_1, z_2, \ldots, z_N)$$

$$= \sum_{p=1}^{P} w_p \left( f_p(z_{1i}, z_{2i}, \ldots, z_{Ni}) + \sum_{n=1}^{N} \left. \frac{\partial f_p(z_1, z_2, \ldots, z_N)}{\partial z_n} \right|_{z_1=z_{1i}, z_2=z_{2i}, \ldots, z_N=z_{Ni,}} (z_n - z_{ni}) \right)^2 \quad \text{(Eq. 4)}$$

which is a quadratic function of the design variables $(z_1, z_2,...,z_N)$. Every term is constant except the design variables $(z_1, z_2,...,z_N)$.

If the design variables $(z_1, z_2,...,z_N)$ are not under any constraints, $(z_{1(i+1)}, z_{2(i+1)},...,z_{N(i+1)})$ can be derived by

$$\frac{\partial CF(z_1, z_2, \ldots, z_N)}{\partial z_n} = 0,$$

solving by N linear equations:          wherein $n = 1,2,...N$.

If the design variables $(z_1, z_2,...,z_N)$ are under the constraints in the form of $J$ inequalities (e.g. tuning ranges of

$$\sum_{n=1}^{N} A_{nj} z_n \leq B_j,$$

$(z_1, z_2,...,z_N))$      for $j = 1,2,...J$; and $K$ equalities (e.g. interdependence between the design variables)

$$\sum_{n=1}^{N} C_{nk} z_n = D_k \, ,$$

for $k = 1,2,...K$; the optimization process becomes a classic quadratic programming problem, wherein $A_{nj}$, $B_j$, $C_{nk}$, $D_k$ are constants. Additional constraints can be imposed for each iteration. For example, a "damping factor" $\Delta_D$ can be introduced to limit the difference between $(z_{1(i+1)}, z_{2(i+1)},...,z_{N(i+1)})$ and $(z_{1i}, z_{2i},...,z_{Ni})$, so that the approximation of Eq. 3 holds. Such constraints can be expressed as $z_{ni} - \Delta_D \le z_n \le z_{ni} + \Delta_D$. $(z_{1(i+1)}, z_{2(i+1)},...,z_{N(i+1)})$ can be derived using, for example, methods described in Numerical Optimization (2nd ed.) by Jorge Nocedal and Stephen J. Wright (Berlin New York: Vandenberghe. Cambridge University Press).

Instead of minimizing the RMS of $f_p(z_1, z_2,...,z_N)$, the optimization process can minimize magnitude of the largest deviation (the worst defect) among the evaluation points to their intended values. In this approach, the cost function can alternatively be expressed as

$$CF(z_1, z_2, \ldots, z_N) = \max_{1 \le p \le P} \frac{f_p(z_1, z_2, \ldots, z_N)}{CL_p} \qquad \text{(Eq. 5),}$$

wherein $CL_p$ is the maximum allowed value for $f_p(z_1, z_2,...,z_N)$. This cost function represents the worst defect among the evaluation points. Optimization using this cost function minimizes magnitude of the worst defect. An iterative greedy algorithm can be used for this optimization.

The cost function of Eq. 5 can be approximated as:

$$CF(z_1, z_2, \ldots, z_N) = \sum_{p=1}^{P} \left( \frac{f_p(z_1, z_2, \ldots, z_N)}{CL_p} \right)^q \qquad \text{(Eq. 6),}$$

wherein q is an even positive integer such as at least 4, preferably at least 10. Eq. 6 mimics the behavior of Eq. 5, while allowing the optimization to be executed analytically and accelerated by using methods such as the deepest descent method, the conjugate gradient method, etc.

Minimizing the worst defect size can also be combined with linearizing of $f_p(z_1, z_2,...,z_N)$. Specifically, $f_p(z_1, z_2,...,z_N)$ is approximated as in Eq. 3. Then the constraints on worst defect size are written as inequalities $E_{Lp} \le f_p(z_1, z_2,...,z_N) \le E_{Up}$, wherein $E_{Lp}$ and $E_{Up}$ are two constants specifying the minimum and maximum allowed deviation for the $f_p(z_1, z_2,...,z_N)$. Plugging Eq. 3 in, these constraints are transformed to, for p=1,...P,

$$\sum_{n=1}^{N} \left. \frac{\partial f_p(z_1, z_2, \ldots, z_N)}{\partial z_n} \right|_{z_1 = z_{1i}, z_2 = z_{2i}, \ldots, z_N = z_{Ni},} z_n \le E_{Up} + \sum_{n=1}^{N} \left. \frac{\partial f_p(z_1, z_2, \ldots, z_N)}{\partial z_n} \right|_{z_1 = z_{1i}, z_2 = z_{2i}, \ldots, z_N = z_{Ni},} z_{ni} - f_p(z_{1i}, z_{2i}, \ldots, z_{Ni})$$

$$\text{(Eq. 6')}$$

and

$$-\sum_{n=1}^{N} \left. \frac{\partial f_p(z_1, z_2, \ldots, z_N)}{\partial z_n} \right|_{z_1 = z_{1i}, z_2 = z_{2i}, \ldots, z_N = z_{Ni},} z_n \le -E_{Up} - \sum_{n=1}^{N} \left. \frac{\partial f_p(z_1, z_2, \ldots, z_N)}{\partial z_n} \right|_{z_1 = z_{1i}, z_2 = z_{2i}, \ldots, z_N = z_{Ni},} z_{ni} + f_p(z_{1i}, z_{2i}, \ldots, z_{Ni})$$

$$\text{(Eq. 6'')}$$

Since Eq. 3 is generally valid only in the vicinity of $(z_{1i}, z_{2i},...,z_{Ni})$, in case the desired constraints $E_{Lp} \le f_p(z_1, z_2,...,z_N) \le E_{Up}$ cannot be achieved in such vicinity, which can be determined by any conflict among the inequalities, the constants $E_{Lp}$ and $E_{Up}$ can be relaxed until the constraints are achievable. This optimization process minimizes the worst defect size in the vicinity of $(z_{1i}, z_{2i},...,z_{Ni})$. Then each step reduces the worst defect size gradually, and each step is executed iteratively until certain terminating conditions are met. This will lead to optimal reduction of the worst defect size.

Another way to minimize the worst defect is to adjust the weight $w_p$ in each iteration. For example, after the i-th iteration, if the r-th evaluation point is the worst defect, $w_r$ can be increased in the $(i+1)$-th iteration so that the reduction of that evaluation point's defect size is given higher priority.

In addition, the cost functions in Eq.4 and Eq.5 can be modified by introducing a Lagrange multiplier to achieve compromise between the optimization on RMS of the defect size and the optimization on the worst defect size, i.e.,

$$CF(z_1, z_2, \ldots, z_N) = (1-\lambda)\sum_{p=1}^{P} w_p f_p^2(z_1, z_2, \ldots, z_N) + \lambda \max_{1 \le p \le P} \frac{f_p(z_1, z_2, \ldots, z_N)}{CL_p} \quad (\text{Eq. 6'''})$$

where $\lambda$ is a preset constant that specifies the trade-off between the optimization on RMS of the defect size and the optimization on the worst defect size. In particular, if $\lambda=0$, then this becomes Eq.4 and the RMS of the defect size is only minimized; while if $\lambda=1$, then this becomes Eq.5 and the worst defect size is only minimized; if $0<\lambda<1$, then both are taken into consideration in the optimization. Such optimization can be solved using multiple methods. For example, the weighting in each iteration may be adjusted, similar to the one described previously. Alternatively, similar to minimizing the worst defect size from inequalities, the inequalities of Eq. 6' and 6'' can be viewed as constraints of the design variables during solution of the quadratic programming problem. Then, the bounds on the worst defect size can be relaxed incrementally or increase the weight for the worst defect size incrementally, compute the cost function value for every achievable worst defect size, and choose the design variable values that minimize the total cost function as the initial point for the next step. By doing this iteratively, the minimization of this new cost function can be achieved.

Optimizing a lithographic projection apparatus can expand the process window. A larger process window provides more flexibility in process design and chip design. The process window can be defined as a set of focus and dose values for which the resist image are within a certain limit of the design target of the resist image. Note that all the methods discussed here may also be extended to a generalized process window definition that can be established by different or additional base parameters in addition to exposure dose and defocus. These may include, but are not limited to, optical settings such as NA, sigma, aberrations, polarization, or optical constants of the resist layer. For example, as described earlier, if the PW also consists of different mask bias, then the optimization includes the minimization of MEEF (Mask Error Enhancement Factor), which is defined as the ratio between the substrate EPE and the induced mask edge bias. The process window defined on focus and dose values only serve as an example in this disclosure. A method of maximizing the process window, according to an embodiment, is described below.

In a first step, starting from a known condition $(f_0, \varepsilon_0)$ in the process window, wherein fo is a nominal focus and $\varepsilon_0$ is a nominal dose, minimizing one of the cost functions below in the vicinity $(f_0 \pm \Delta f, \varepsilon_0 \pm \Delta \varepsilon)$:

$$CF(z_1, z_2, \ldots, z_N, f_0, \varepsilon_0) = \max_{(f,\varepsilon)=(f_0 \pm \Delta f, \varepsilon_0 \pm \Delta \varepsilon)} \max_p \left| f_p(z_1, z_2, \ldots, z_N, f, \varepsilon) \right| \quad (\text{Eq. 7}).$$

or

$$CF(z_1, z_2, \ldots, z_N, f_0, \varepsilon_0) = \sum_{(f,\varepsilon)=(f_0 \pm \Delta f, \varepsilon_0 \pm \Delta \varepsilon)} \sum_p w_p f_p^2(z_1, z_2, \ldots, z_N, f, \varepsilon) \quad (\text{Eq. 7'})$$

or

$$CF(z_1, z_2, \ldots, z_N, f_0, \varepsilon_0) =$$
$$(1-\lambda) \sum_{(f,\varepsilon)=(f_0 \pm \Delta f, \varepsilon_0 \pm \Delta \varepsilon)} \sum_p w_p f_p^2(z_1, z_2, \ldots, z_N, f, \varepsilon) + \lambda \max_{(f,\varepsilon)=(f_0 \pm \Delta f, \varepsilon_0 \pm \Delta \varepsilon)} \max_p \left| f_p(z_1, z_2, \ldots, z_N, f, \varepsilon) \right|$$

$$(\text{Eq.7''})$$

If the nominal focus $f_0$ and nominal dose $\varepsilon_0$ are allowed to shift, they can be optimized jointly with the design variables $(z_1, z_2, \ldots, z_N)$. In the next step, $(f_0 \pm \Delta f, \varepsilon_0 \pm \Delta \varepsilon)$ is accepted as part of the process window, if a set of values of $(z_1, z_2, \ldots, z_N, f, \varepsilon)$ can be found such that the cost function is within a preset limit.

Alternatively, if the focus and dose are not allowed to shift, the design variables $(z_1, z_2, \ldots, z_N)$ are optimized with the focus and dose fixed at the nominal focus $f_0$ and nominal dose $\varepsilon_0$. In an alternative embodiment, $(f_0 \pm \Delta f, \varepsilon_0 \pm \Delta \varepsilon)$ is accepted as part of the process window, if a set of values of $(z_1, z_2, \ldots, z_N)$ can be found such that the cost function is within a preset limit.

The methods described earlier in this disclosure can be used to minimize the respective cost functions of Eqs. 7, 7', or 7". If the design variables are characteristics of the projection optics, such as the Zernike coefficients, then minimizing the cost functions of Eqs. 7, 7', or 7" leads to process window maximization based on projection optics optimization, i.e., LO. If the design variables are characteristics of the source and patterning device in addition to those of the projection optics, then minimizing the cost function of Eqs. 7, 7', or 7" leads to process window maximizing based on SMLO, as illustrated in Figure 14. If the design variables are characteristics of the source and patterning device and, then minimizing the cost functions of Eqs. 7, 7', or 7" leads to process window maximization based on SMO. The cost functions of Eqs. 7, 7', or 7" can also include at least one $f_p(z_1,z_2,...,z_N)$ such as that in Eq. 7 or Eq. 8, that is a function of one or more stochastic effects such as the LWR or local CD variation of 2D features, and throughput.

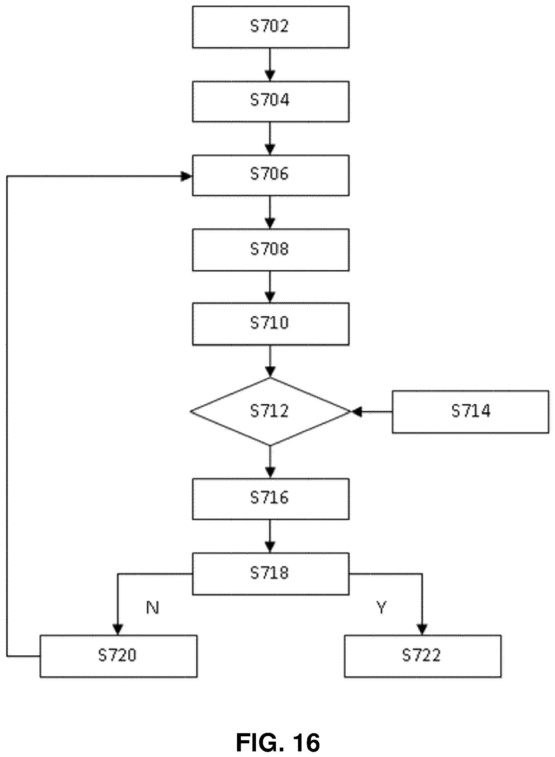

Figure 16 shows one specific example of how a simultaneous SMLO process can use a Gauss Newton Algorithm for optimization. In step S702, starting values of design variables are identified. Tuning ranges for each variable may also be identified. In step S704, the cost function is defined using the design variables. In step S706 cost function is expanded around the starting values for all evaluation points in the design layout. In optional step S710, a full-chip simulation is executed to cover all critical patterns in a full-chip design layout. Desired lithographic response metric (such as CD or EPE) is obtained in step S714, and compared with predicted values of those quantities in step S712. In step S716, a process window is determined. Steps S718, S720, and S722 are similar to corresponding steps S514, S516 and S518, as described with respect to Figure 15A. As mentioned before, the final output may be a wavefront aberration map in the pupil plane, optimized to produce the desired imaging performance. The final output may also be an optimized source map or an optimized design layout.

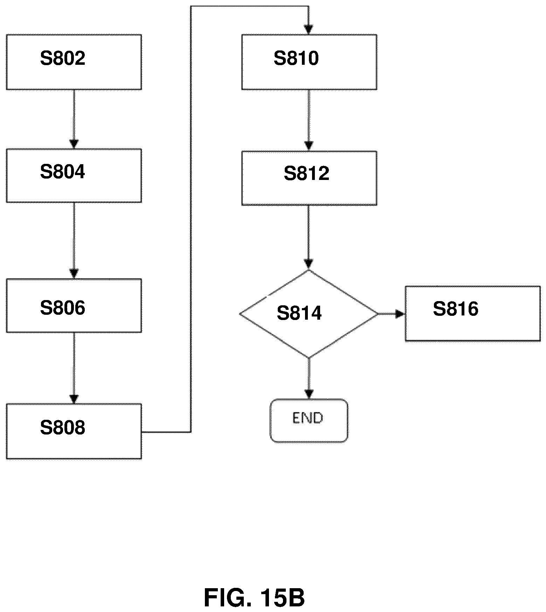

Figure 15B shows an exemplary method to optimize the cost function where the design variables $(z_1,z_2,...,z_N)$ include design variables that may only assume discrete values.

The method starts by defining the pixel groups of the illumination source and the patterning device tiles of the patterning device (step S802). Generally, a pixel group or a patterning device tile may also be referred to as a division of a lithographic process component. In one exemplary approach, the illumination source is divided into 117 pixel groups, and 94 patterning device tiles are defined for the patterning device, substantially as described above, resulting in a total of 211 divisions.

In step S804, a lithographic model is selected as the basis for photolithographic simulation. Photolithographic simulations produce results that are used in calculations of photolithographic metrics, or responses. A particular photolithographic metric is defined to be the performance metric that is to be optimized (step S806). In step S808, the initial (pre-optimization) conditions for the illumination source and the patterning device are set up. Initial conditions include initial states for the pixel groups of the illumination source and the patterning device tiles of the patterning device such that references may be made to an initial illumination shape and an initial patterning device pattern. Initial conditions may also include mask bias, NA, and focus ramp range. Although steps S802, S804, S806, and S808 are depicted as sequential steps, it will be appreciated that in other embodiments of the invention, these steps may be performed in other sequences.

In step S810, the pixel groups and patterning device tiles are ranked. Pixel groups and patterning device tiles may be interleaved in the ranking. Various ways of ranking may be employed, including: sequentially (e.g., from pixel group 1 to pixel group 117 and from patterning device tile 1 to patterning device tile 94), randomly, according to the physical locations of the pixel groups and patterning device tiles (e.g., ranking pixel groups closer to the center of the illumination source higher), and according to how an alteration of the pixel group or patterning device tile affects the performance metric.

Once the pixel groups and patterning device tiles are ranked, the illumination source and patterning device are adjusted to improve the performance metric (step S812). In step S812, each of the pixel groups and patterning device tiles are analyzed, in order of ranking, to determine whether an alteration of the pixel group or patterning device tile will result in an improved performance metric. If it is determined that the performance metric will be improved, then the pixel group or patterning device tile is accordingly altered, and the resulting improved performance metric and modified illumination shape or modified patterning device pattern form the baseline for comparison for subsequent analyses of lower-ranked pixel groups and patterning device tiles. In other words, alterations that improve the performance metric are retained. As alterations to the states of pixel groups and patterning device tiles are made and retained, the initial illumination shape and initial patterning device pattern changes accordingly, so that a modified illumination shape and a modified patterning device pattern result from the optimization process in step S812.

In other approaches, patterning device polygon shape adjustments and pairwise polling of pixel groups or patterning device tiles are also performed within the optimization process of S812.

In an alternative embodiment the interleaved simultaneous optimization procedure may include to alter a pixel group of the illumination source and if an improvement of the performance metric is found, the dose is stepped up and down to look for further improvement. In a further alternative embodiment the stepping up and down of the dose or intensity may be replaced by a bias change of the patterning device pattern to look for further improvement in the simultaneous optimization procedure.

In step S814, a determination is made as to whether the performance metric has converged. The performance metric may be considered to have converged, for example, if little or no improvement to the performance metric has been witnessed in the last several iterations of steps S810 and S812. If the performance metric has not converged, then the steps of S810 and S812 are repeated in the next iteration, where the modified illumination shape and modified patterning device from the current iteration are used as the initial illumination shape and initial patterning device for the next iteration (step S816).

The optimization methods described above may be used to increase the throughput of the lithographic projection apparatus. For example, the cost function may include an $f_p(z_1, z_2, ..., z_N)$ that is a function of the exposure time. Optimization of such a cost function is preferably constrained or influenced by a measure of the stochastic effects or other metrics. Specifically, a computer-implemented method for increasing a throughput of a lithographic process may include optimizing a cost function that is a function of one or more stochastic effects of the lithographic process and a function of an exposure time of the substrate, in order to minimize the exposure time.

In one embodiment, the cost function includes at least one $f_p(z_1, z_2, ..., z_N)$ that is a function of one or more stochastic effects. The stochastic effects may include the failure of a feature, measurement data (e.g., SEPE) determined as in method of Figure 3, LWR or local CD variation of 2D features. In one embodiment, the stochastic effects include stochastic variations of characteristics of a resist image. For example, such stochastic variations may include failure rate of a feature, line edge roughness (LER), line width roughness (LWR) and critical dimension uniformity (CDU). Including stochastic variations in the cost function allows finding values of design variables that minimize the stochastic variations, thereby reducing risk of defects due to stochastic effects.

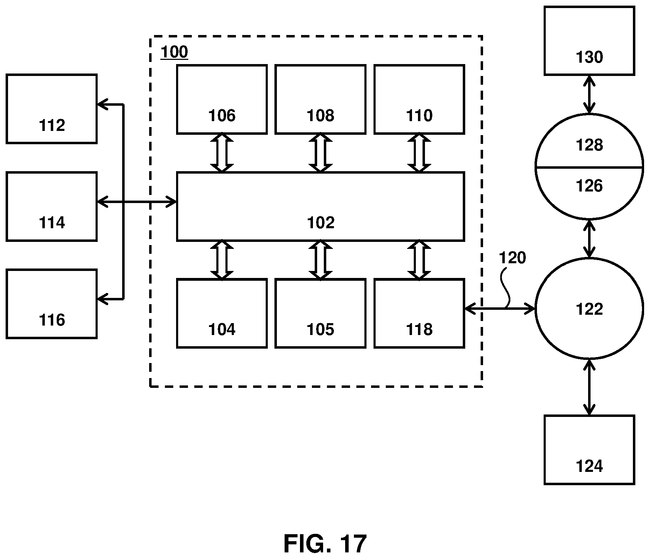

Figure 17 is a block diagram that illustrates a computer system 100 which can assist in implementing in various methods and systems disclosed herein. Computer system 100 includes a bus 102 or other communication mechanism for communicating information, and a processor 104 (or multiple processors 104 and 105) coupled with bus 102 for processing information. Computer system 100 also includes a main memory 106, such as a random access memory (RAM) or other dynamic storage device, coupled to bus 102 for storing information and instructions to be executed by processor 104. Main memory 106 also may be used for storing temporary variables or other intermediate information during execution of instructions to be executed by processor 104. Computer system 100 further includes a read only memory (ROM) 108 or other static storage device coupled to bus 102 for storing static information and instructions for processor 104. A storage device 110, such as a magnetic disk or optical disk, is provided and coupled to bus 102 for storing information and instructions.

Computer system 100 may be coupled via bus 102 to a display 112, such as a cathode ray tube (CRT) or flat panel or touch panel display for displaying information to a computer user. An input device 114, including alphanumeric and other keys, is coupled to bus 102 for communicating information and command selections to processor 104. Another type of user input device is cursor control 116, such as a mouse, a trackball, or cursor direction keys for communicating direction information and command selections to processor 104 and for controlling cursor movement on display 112. This input device typically has two degrees of freedom in two axes, a first axis (e.g., x) and a second axis (e.g., y), that allows the device to specify positions in a plane. A touch panel (screen) display may also be used as an input device.

According to one embodiment, portions of one or more methods described herein may be performed by computer system 100 in response to processor 104 executing one or more sequences of one or more instructions contained in main memory 106. Such instructions may be read into main memory 106 from another computer-readable medium, such as storage device 110. Execution of the sequences of instructions contained in main memory 106 causes processor 104 to perform the process steps described herein. One or more processors in a multi-processing arrangement may also be employed to execute the sequences of instructions contained in main memory 106. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 104 for execution. Such a medium may take many forms, including but not limited to, non-volatile media, volatile media, and transmission media. Non-volatile media include, for example, optical or magnetic disks, such as storage device 110. Volatile media include dynamic memory, such as main memory 106. Transmission media include coaxial cables, copper wire and fiber optics, including the wires that comprise bus 102. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 104 for execution. For example, the instructions may initially be borne on a magnetic disk of a remote computer. The remote computer can load the instructions into its dynamic memory and send the instructions over a telephone line using a modem. A modem local to computer system 100 can receive the data on the telephone line and use an infrared transmitter to convert the data to an infrared signal. An infrared detector coupled to bus 102 can receive the data carried in the infrared signal and place the data on bus 102. Bus 102 carries the data to main memory 106, from which processor 104 retrieves and executes the instructions. The instructions received by main memory 106 may optionally be stored on storage device 110 either before or after execution by processor 104.

Computer system 100 also preferably includes a communication interface 118 coupled to bus 102. Communication interface 118 provides a two-way data communication coupling to a network link 120 that is connected to a local network 122. For example, communication interface 118 may be an integrated services digital network (ISDN) card or a modem to provide a data communication connection to a corresponding type of telephone line. As another example, communication interface 118 may be a local area network (LAN) card to provide a data communication connection to a compatible LAN. Wireless links may also be implemented. In any such implementation, communication interface 118 sends and receives electrical, electromagnetic or optical signals that carry digital data streams representing various types of information.

Network link 120 typically provides data communication through one or more networks to other data devices. For example, network link 120 may provide a connection through local network 122 to a host computer 124 or to data equipment operated by an Internet Service Provider (ISP) 126. ISP 126 in turn provides data communication services through the worldwide packet data communication network, now commonly referred to as the "Internet" 128. Local network 122 and Internet 128 both use electrical, electromagnetic or optical signals that carry digital data streams. The signals through the various networks and the signals on network link 120 and through communication interface 118, which carry the digital data to and from computer system 100, are exemplary forms of carrier waves transporting the information.

Computer system 100 can send messages and receive data, including program code, through the network(s), network link 120, and communication interface 118. In the Internet example, a server 130 might transmit a requested code for an application program through Internet 128, ISP 126, local network 122 and communication interface 118. One such downloaded application may provide for the illumination optimization of the embodiment, for example. The received code may be executed by processor 104 as it is received, or stored in storage device 110, or other non-volatile storage for later execution. In this manner, computer system 100 may obtain application code in the form of a carrier wave.

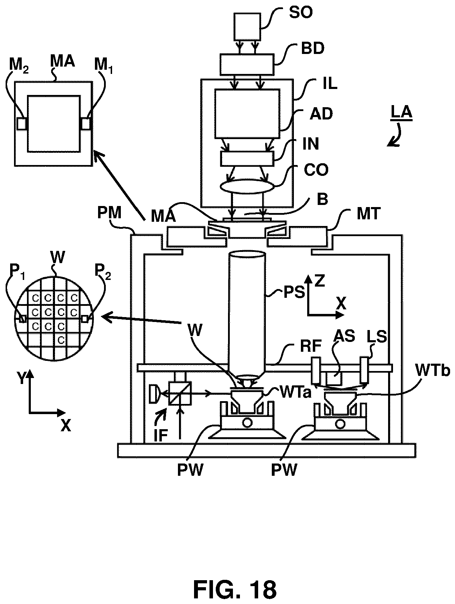

Figure 18 schematically depicts an exemplary lithographic projection apparatus whose illumination source could be optimized utilizing the methods described herein. The apparatus comprises:

- an illumination system IL, to condition a beam B of radiation. In this particular case, the illumination system also comprises a radiation source SO;
- a first object table (e.g., mask table) MT provided with a patterning device holder to hold a patterning device MA (e.g., a reticle), and connected to a first positioner to accurately position the patterning device with respect to item PS;
- a second object table (substrate table) WT provided with a substrate holder to hold a substrate W (e.g., a resist-coated silicon wafer), and connected to a second positioner to accurately position the substrate with respect to item PS;
- a projection system ("lens") PS (e.g., a refractive, catoptric or catadioptric optical system) to image an irradiated portion of the patterning device MA onto a target portion C (e.g., comprising one or more dies) of the substrate W.

As depicted herein, the apparatus is of a transmissive type (i.e., has a transmissive mask). However, in general, it may also be of a reflective type, for example (with a reflective mask). Alternatively, the apparatus may employ another kind of patterning device as an alternative to the use of a classic mask; examples include a programmable mirror array or LCD matrix.

The source SO (e.g., a mercury lamp or excimer laser) produces a beam of radiation. This beam is fed into an illumination system (illuminator) IL, either directly or after having traversed conditioning means, such as a beam expander Ex, for example. The illuminator IL may comprise adjusting means AD for setting the outer or inner radial extent (commonly referred to as $\sigma$-outer and $\sigma$-inner, respectively) of the intensity distribution in the beam. In addition, it will generally comprise various other components, such as an integrator IN and a condenser CO. In this way, the beam B impinging on the patterning device MA has a desired uniformity and intensity distribution in its cross-section.

It should be noted with regard to Figure 18 that the source SO may be within the housing of the lithographic projection apparatus (as is often the case when the source SO is a mercury lamp, for example), but that it may also be remote from the lithographic projection apparatus, the radiation beam that it produces being led into the apparatus (e.g., with the aid of suitable directing mirrors); this latter scenario is often the case when the source SO is an excimer laser (e.g., based on KrF, ArF or $F_2$ lasing).

The beam PB subsequently intercepts the patterning device MA, which is held on a patterning device table MT. Having traversed the patterning device MA, the beam B passes through the lens PL, which focuses the beam B onto a target portion C of the substrate W. With the aid of the second positioning means (and interferometric measuring means IF), the substrate table WT can be moved accurately, e.g. so as to position different target portions C in the path of the beam PB. Similarly, the first positioning means can be used to accurately position the patterning device MA with respect to the path of the beam B, e.g., after mechanical retrieval of the patterning device MA from a patterning device library, or during a scan. In general, movement of the object tables MT, WT will be realized with the aid of a long-stroke module (coarse positioning) and a short-stroke module (fine positioning), which are not explicitly depicted in Figure 18. However, in the case of a wafer stepper (as opposed to a step-and-scan tool) the patterning device table MT may just be connected to a short stroke actuator, or may be fixed.

The depicted tool can be used in two different modes:

- In step mode, the patterning device table MT is kept essentially stationary, and an entire patterning device image is projected in one go (i.e., a single "flash") onto a target portion C. The substrate table WT is then shifted in the x or y directions so that a different target portion C can be irradiated by the beam PB;
- In scan mode, essentially the same scenario applies, except that a given target portion C is not exposed in a single "flash". Instead, the patterning device table MT is movable in a given direction (the so-called "scan direction", e.g., the y direction) with a speed v, so that the projection beam B is caused to scan over a patterning device image; concurrently, the substrate table WT is simultaneously moved in the same or opposite direction at a speed $V = Mv$, in which M is the magnification of the lens PL (typically, M = 1/4 or 1/5). In this manner, a relatively large target portion C can be exposed, without having to compromise on resolution.

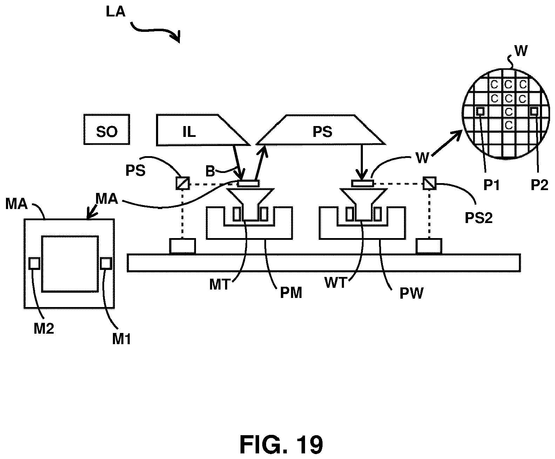

Figure 19 schematically depicts another exemplary lithographic projection apparatus LA whose illumination source could be optimized utilizing the methods described herein.

The lithographic projection apparatus LA includes:

- a source collector module SO
- an illumination system (illuminator) IL configured to condition a radiation beam B (e.g. EUV radiation).
- a support structure (e.g. a mask table) MT constructed to support a patterning device (e.g. a mask or a reticle) MA and connected to a first positioner PM configured to accurately position the patterning device;
- a substrate table (e.g. a wafer table) WT constructed to hold a substrate (e.g. a resist coated wafer) W and connected to a second positioner PW configured to accurately position the substrate; and
- a projection system (e.g. a reflective projection system) PS configured to project a pattern imparted to the radiation beam B by patterning device MA onto a target portion C (e.g. comprising one or more dies) of the substrate W.

As here depicted, the apparatus LA is of a reflective type (e.g. employing a reflective mask). It is to be noted that because most materials are absorptive within the EUV wavelength range, the mask may have multilayer reflectors comprising, for example, a multi-stack of Molybdenum and Silicon. In one example, the multi-stack reflector has a 40 layer pairs of Molybdenum and Silicon where the thickness of each layer is a quarter wavelength. Even smaller wavelengths may be produced with X-ray lithography. Since most material is absorptive at EUV and x-ray wavelengths, a thin piece of patterned absorbing material on the patterning device topography (e.g., a TaN absorber on top of the multilayer reflector) defines where features would print (positive resist) or not print (negative resist).

Referring to Figure 19, the illuminator IL receives an extreme ultra violet radiation beam from the source collector module SO. Methods to produce EUV radiation include, but are not necessarily limited to, converting a material into a plasma state that has at least one element, e.g., xenon, lithium or tin, with one or more emission lines in the EUV range. In one such method, often termed laser produced plasma ("LPP") the plasma can be produced by irradiating a fuel, such as a droplet, stream or cluster of material having the line-emitting element, with a laser beam. The source collector module SO may be part of an EUV radiation system including a laser, not shown in Figure 19, for providing the laser beam exciting the fuel. The resulting plasma emits output radiation, e.g., EUV radiation, which is collected using a radiation collector, disposed in the source collector module. The laser and the source collector module may be separate entities, for example when a CO2 laser is used to provide the laser beam for fuel excitation.

In such cases, the laser is not considered to form part of the lithographic apparatus and the radiation beam is passed from the laser to the source collector module with the aid of a beam delivery system comprising, for example, suitable directing mirrors or a beam expander. In other cases the source may be an integral part of the source collector module, for example when the source is a discharge produced plasma EUV generator, often termed as a DPP source.

The illuminator IL may comprise an adjuster for adjusting the angular intensity distribution of the radiation beam. Generally, at least the outer or inner radial extent (commonly referred to as $\sigma$-outer and $\sigma$-inner, respectively) of the intensity distribution in a pupil plane of the illuminator can be adjusted. In addition, the illuminator IL may comprise various other components, such as facetted field and pupil mirror devices. The illuminator may be used to condition the radiation beam, to have a desired uniformity and intensity distribution in its cross section.

The radiation beam B is incident on the patterning device (e.g., mask) MA, which is held on the support structure (e.g., mask table) MT, and is patterned by the patterning device. After being reflected from the patterning device (e.g. mask) MA, the radiation beam B passes through the projection system PS, which focuses the beam onto a target portion C of the substrate W. With the aid of the second positioner PW and position sensor PS2 (e.g. an interferometric device, linear encoder or capacitive sensor), the substrate table WT can be moved accurately, e.g. so as to position different target portions C in the path of the radiation beam B. Similarly, the first positioner PM and another position sensor PS1 can be used to accurately position the patterning device (e.g. mask) MA with respect to the path of the radiation beam B. Patterning device (e.g. mask) MA and substrate W may be aligned using patterning device alignment marks M1, M2 and substrate alignment marks PI, P2.

The depicted apparatus LA could be used in at least one of the following modes:

1. In step mode, the support structure (e.g. mask table) MT and the substrate table WT are kept essentially stationary, while an entire pattern imparted to the radiation beam is projected onto a target portion C at one time (i.e. a single static exposure). The substrate table WT is then shifted in the X or Y direction so that a different target portion C can be exposed.

2. In scan mode, the support structure (e.g. mask table) MT and the substrate table WT are scanned synchronously while a pattern imparted to the radiation beam is projected onto a target portion C (i.e. a single dynamic exposure). The velocity and direction of the substrate table WT relative to the support structure (e.g. mask table) MT may be determined by the (de-)magnification and image reversal characteristics of the projection system PS.

3. In another mode, the support structure (e.g. mask table) MT is kept essentially stationary holding a programmable patterning device, and the substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

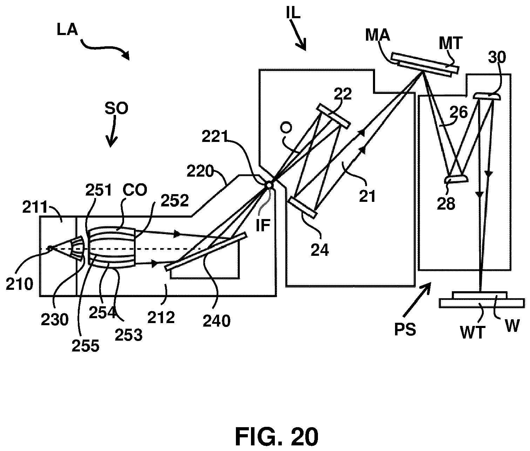

Figure 20 shows the apparatus LA in more detail, including the source collector module SO, the illumination system IL, and the projection system PS. The source collector module SO is constructed and arranged such that a vacuum environment can be maintained in an enclosing structure 220 of the source collector module SO. An EUV radiation emitting plasma 210 may be formed by a discharge produced plasma source. EUV radiation may be produced by a gas or vapor, for example Xe gas, Li vapor or Sn vapor in which the very hot plasma 210 is created to emit radiation in the EUV range of the electromagnetic spectrum. The very hot plasma 210 is created by, for example, an electrical discharge causing an at least partially ionized plasma. Partial pressures of, for example, 10 Pa of Xe, Li, Sn vapor or any other suitable gas or vapor may be required for efficient generation of the radiation. In an embodiment, a plasma of excited tin (Sn) is provided to produce EUV radiation.

The radiation emitted by the hot plasma 210 is passed from a source chamber 211 into a collector chamber 212 via an optional gas barrier or contaminant trap 230 (in some cases also referred to as contaminant barrier or foil trap) which is positioned in or behind an opening in source chamber 211. The contaminant trap 230 may include a channel structure. Contamination trap 230 may also include a gas barrier or a combination of a gas barrier and a channel structure. The contaminant trap or contaminant barrier 230 further indicated herein at least includes a channel structure, as known in the art.

The collector chamber 211 may include a radiation collector CO which may be a so-called grazing incidence collector. Radiation collector CO has an upstream radiation collector side 251 and a downstream radiation collector side 252. Radiation that traverses collector CO can be reflected off a grating spectral filter 240 to be focused in a virtual source point IF along the optical axis indicated by the dot-dashed line 'O'. The virtual source point IF is commonly referred to as the intermediate focus, and the source collector module is arranged such that the intermediate focus IF is located at or near an opening 221 in the enclosing structure 220. The virtual source point IF is an image of the radiation emitting plasma 210.

Subsequently the radiation traverses the illumination system IL, which may include a facetted field mirror device 22 and a facetted pupil mirror device 24 arranged to provide a desired angular distribution of the radiation beam 21, at the patterning device MA, as well as a desired uniformity of radiation intensity at the patterning device MA. Upon reflection of the beam of radiation 21 at the patterning device MA, held by the support structure MT, a patterned beam 26 is formed and the patterned beam 26 is imaged by the projection system PS via reflective elements 28, 30 onto a substrate W held by the substrate table WT.

More elements than shown may generally be present in illumination optics unit IL and projection system PS. The grating spectral filter 240 may optionally be present, depending upon the type of lithographic apparatus. Further, there may be more mirrors present than those shown in the figures, for example there may be 1- 6 additional reflective elements present in the projection system PS than shown in Figure 20.

Collector optic CO, as illustrated in Figure 20, is depicted as a nested collector with grazing incidence reflectors 253, 254 and 255, just as an example of a collector (or collector mirror). The grazing incidence reflectors 253, 254 and 255 are disposed axially symmetric around the optical axis O and a collector optic CO of this type is preferably used in combination with a discharge produced plasma source, often called a DPP source.

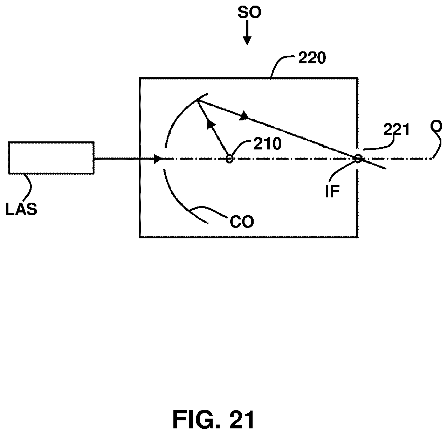

Alternatively, the source collector module SO may be part of an LPP radiation system as shown in Figure 21. A laser LA is arranged to deposit laser energy into a fuel, such as xenon (Xe), tin (Sn) or lithium (Li), creating the highly ionized plasma 210 with electron temperatures of several 10's of eV. The energetic radiation generated during de-excitation and recombination of these ions is emitted from the plasma, collected by a near normal incidence collector optic CO and focused onto the opening 221 in the enclosing structure 220.

The embodiments may further be described using the following clauses:

1. A non-transitory computer-readable medium having instructions that, when executed by a computer, cause the computer to execute a method for decomposing error contributions from multiple sources to multiple features of a pattern printed on a substrate, the method comprising:

obtaining an image of the pattern on the substrate;
obtaining, using the image, a plurality of measurement values of a feature of the pattern, wherein the measurement values are obtained for different sensor values;
correlating, using a decomposition method, each measurement value of the plurality of measurement values to a linear mixture of the error contributions to generate a plurality of linear mixtures of the error contributions; and
deriving, from the linear mixtures and using the decomposition method, each of the error contributions.

2. The computer-readable medium of clause 1, wherein the different sensor values correspond to different threshold values associated with the image in which each threshold value corresponds to a threshold of a pixel value in the image.

3. The computer-readable medium of clause 2, wherein each measurement value corresponds to a critical dimension (CD) value of the feature at one of the different threshold values.

4. The computer-readable medium of clause 2, wherein the error contributions include:

an image acquisition tool error contribution that is associated with an image acquisition tool used to acquire the image,
a mask error contribution that is associated with a mask used to print the pattern on the substrate, and
a resist error contribution that is associated with a resist used to print the pattern, wherein the resist error contribution includes photoresist chemical noise and a shot noise associated with a source of a lithographic apparatus used to print the pattern.

5. The computer-readable medium of clause 4 further comprising:
adjusting, based on the mask error contribution, one or more parameters of at least one of the mask or a source of a lithographic apparatus used to print the pattern.

6. The computer-readable medium of clause 4 further comprising:
adjusting, based on the resist error contribution, one or more parameters of at least one of the mask or a source of a lithographic apparatus used to print the pattern.

7. The computer-readable medium of any of clauses 3-6, wherein obtaining the measurement values includes:

obtaining a first signal having a first plurality of delta CD values from a plurality of measurement points at a first threshold value of the different threshold values,
obtaining a second signal having a second plurality of delta CD values from the plurality of measurement points at a second threshold value of the different threshold values, and
obtaining a third signal having a third plurality of delta CD values from the plurality of measurement points at a third threshold value of the different threshold values.

8. The computer-readable medium of clause 7, wherein each delta CD value is determined per threshold value and per measurement point, and indicates a deviation of a CD value of a given feature from a mean value of a plurality of CD values of the features.

9. The computer-readable medium of clause 7, wherein each delta CD value indicates, at a given threshold value, a distance between a specified point on a contour of a given feature to a reference point on a reference contour of the given feature, wherein the reference contour is a simulated version of the contour of the given feature.

10. The computer-readable medium of clause 7, wherein correlating each measurement value includes:

correlating each of the first plurality of delta CD values in the first signal to a first linear mixture of the image acquisition tool, mask and resist error contributions,

correlating each of the second plurality of delta CD values in the second signal to a second linear mixture of the image acquisition tool, mask and resist error contributions, and

correlating each of the third plurality of delta CD values in the third signal to a third linear mixture of the image acquisition tool, mask and resist error contributions.

11. The computer-readable medium of clause 10, wherein deriving each of the error contributions includes: deriving, using the first, second, and third linear mixtures, and from each of the first plurality, second plurality, and third plurality of delta CD values: (a) a first output signal having a plurality of the image acquisition tool error contributions, (b) a second output signal having a plurality of the mask error contributions, and (c) a third output signal having a plurality of the resist error contributions.

12. The computer-readable medium of clause 11, wherein each error contribution is determined as a function of the corresponding error contribution at the first, second and third threshold levels.

13. The computer-readable medium of clause 11, wherein deriving each of the error contributions includes:

determining a mixing matrix having a set of coefficients that generates the first, second and third linear mixtures of the error contributions corresponding to each delta CD value from the first plurality, second plurality and third plurality of delta CD values, respectively,

determining an inverse of the mixing matrix, and

using the inverse of the mixing matrix, determining (a) the first output signal having the plurality of the image acquisition tool error contributions, (b) the second output signal having the plurality of the mask error contributions, and (c) the third output signal having the plurality of the resist error contributions, from the first plurality, second plurality and third plurality of delta CD values, respectively.

14. The computer-readable medium of any of clauses 2-3, wherein the obtaining the measurement values includes:

obtaining a first contour of the feature corresponding to a first threshold value of the different threshold values,

obtaining a first CD value of the first contour,

obtaining a second contour of the feature corresponding to a second threshold value of the different threshold values, and

obtaining a second CD value of the second contour.

15. The computer-readable medium of clause 14 further comprising:

obtaining a first delta CD value of the first CD value, wherein the first delta CD indicates a deviation of the first CD value from a mean of a plurality of first CD values measured at a plurality of measurement points at the first threshold value.

16. The computer-readable medium of clause 15, wherein obtaining the first delta CD value includes:

obtaining the plurality of first CD values corresponding to the first threshold value at the plurality of measurement points,

obtaining a mean value of the plurality of first CD values,

shifting the mean value to a zero value, and

obtaining the first delta CD value as a difference between the first CD value and the mean value.

17. The computer-readable medium of clause 15, wherein the plurality of measurement points are located on at least one of (a) the feature or (b) a plurality of features of the pattern.

18. The computer-readable medium of any of clauses 15-17, wherein correlating each measurement value includes:

correlating the first delta CD value corresponding to the first threshold value to a first linear mixture of a first error contribution and a second error contribution of the error contributions, and

correlating a second delta CD value corresponding to the second threshold value to a second linear mixture of the first and second error contributions.

19. The computer-readable medium of clause 18, wherein deriving each of the error contributions includes: deriving, using the decomposition method, the first and second error contributions from the first and second delta CD values, and the first and second linear mixtures.

20. The computer-readable medium of clause 1, wherein the measurement values correspond to a local critical

EP 3 910 418 A1

dimension uniformity (LCDU) value of the feature for the different sensor values.

21. The computer-readable medium of any of clauses 1 and 20, wherein the different sensor values correspond to different dose levels associated with a source of a lithographic apparatus used to print the pattern.

22. The computer-readable medium of any of clauses 1 and 20, wherein the different sensor values correspond to different focus levels associated with a source of a lithographic apparatus used to print the pattern.

23. The computer-readable medium of any of clauses 20-21 further comprising:

obtaining, based on a specified focus level, a first LCDU value corresponding to a first dose level, and
obtaining, based on the specified focus level, a second LCDU value corresponding to a second dose level.

24. The computer-readable medium of any of clauses 20 or 22 further comprising:

obtaining, based on a specified dose level, a first LCDU value corresponding to a first focus level, and
obtaining, based on the specified dose level, a second LCDU value corresponding to a second focus level.

25. The computer-readable medium of any of clauses 23 or 24, wherein correlating each measurement value includes:

correlating the first LCDU value to a first linear mixture of a first error contribution of the error contributions and a second error contribution of the error contributions, and
correlating the second LCDU value to a second linear mixture of the first and second error contributions.

26. The computer-readable medium of clause 25, wherein deriving each of the error contributions includes: deriving, using the decomposition method, the first and second error contributions from the first and second LCDU values, and the first and second linear mixtures.

27. The computer-readable medium of clause 1, wherein the measurement values correspond to a line width roughness (LWR) value of the feature for the different sensor values.

28. A non-transitory computer-readable medium having instructions that, when executed by a computer, cause the computer to execute a method for decomposing error contributions from multiple sources to multiple features associated with a pattern printed on a substrate, the method comprising:

obtaining an image of the pattern;
obtaining a plurality of delta critical dimension (CD) values at different heights of contours of the features of the pattern, wherein the plurality of delta CD values includes (a) a first set of delta CD values of the features corresponding to a first contour height, (b) a second set of delta CD values of the features corresponding to a second contour height, and (c) a third set of delta CD values of the features corresponding a third contour height;
correlating, using a decomposition method, (a) the first set of delta CD values to a first linear mixture of a first, second, and third error contributions, (b) the second set of delta CD values to a second linear mixture of the first, second, and third error contributions, (c) the third set of delta CD values to a third linear mixture of the first, second, and third error contributions; and
deriving, from the linear mixtures and using the decomposition method, the first, second, and third error contributions.

29. The computer-readable medium of clause 28, wherein each delta CD value indicates a deviation of a CD value of a feature from a mean value of a plurality of CD values of the features measured at a plurality of measurement points at a specified contour height.

30. The computer-readable medium of clause 28, wherein each delta CD value indicates, at a given contour height, a distance between a specified point on a contour of a feature to a reference point on a reference contour of the feature, wherein the reference contour is a simulated version of the contour of the given feature.

31. The computer-readable medium of clause 28, wherein each contour height is determined by thresholding pixel values of the image to a specified value.

32. The computer-readable medium of clause 28 further comprising:
adjusting, based on one or more of the error contributions, one or more parameters of at least one of a mask or a source of a lithographic apparatus used to print the pattern.

33. A non-transitory computer-readable medium having instructions that, when executed by a computer, cause the computer to execute a method for decomposing error contributions from multiple sources to multiple features associated with a pattern on a substrate, the method comprising:

obtaining local critical dimension uniformity (LCDU) data associated with the pattern, wherein the LCDU data includes, for a specified focus level of a source of a lithographic apparatus used to print the pattern, (a) a first set of LCDU values of the features of the pattern corresponding to a first dose level of the source, (b) a second set of LCDU values of the features corresponding to a second dose level, and (c) a third set of LCDU values of the features corresponding a third dose level;

correlating, using a decomposition method, (a) the first set of LCDU values to a first linear mixture of a first, second, and third error contributions, (b) the second set of LCDU values to a second linear mixture of the first, second, and third error contributions, and (c) the third set of LCDU values to a third linear mixture of the first, second, and third error contributions; and

deriving, from the linear mixtures and using the decomposition method, the first, second, and third error contributions.

34. A method for decomposing error contributions from multiple sources to multiple features associated with a pattern to be printed on a substrate, the method comprising:

obtaining an image of the pattern on the substrate;

obtaining, using the image, a plurality of measurement values of a feature of the pattern, wherein the measurement values correspond to different threshold values associated with the image;

correlating, using a decomposition method, each measurement value of the plurality of measurement values to a linear mixture of the error contributions to generate a plurality of linear mixtures of the error contributions; and

deriving, from the linear mixtures and using the decomposition method, each of the error contributions.

35. The method of clause 34, wherein each measurement value corresponds to a critical dimension (CD) value of the feature at one of the different threshold values.

36. The method of clause 35, wherein each threshold value corresponds to a threshold of a pixel value in the image.

37. The method of any of clauses 35-36, wherein the error contributions includes:

a first, second and third error contributions to the CD value, wherein the first error contribution is from a resist used to print the pattern, the second error contribution is from a mask used to print the pattern on the substrate, and the third error contribution is from an image acquisition tool used to acquire the image.

38. A method for decomposing error contributions from multiple sources to one or more features associated with a pattern printed on a substrate, the method comprising:

obtaining local critical dimension uniformity (LCDU) data associated with the pattern, wherein the LCDU data includes, for a specified focus level of a source of a lithographic apparatus used to print the pattern, (a) a first set of LCDU values of the sone or more features of the pattern corresponding to a first dose level of the source, (b) a second set of LCDU values of the one or more features corresponding to a second dose level, and (c) a third set of LCDU values of the one or more features corresponding a third dose level;

correlating, using a decomposition method, (a) the first set of LCDU values to a first linear mixture of a first, second, and third error contributions, (b) the second set of LCDU values to a second linear mixture of the first, second, and third error contributions, and (c) the third set of LCDU values to a third linear mixture of the first, second, and third error contributions; and

deriving, from the linear mixtures and using the decomposition method, the first, second, and third error contributions.

39. An apparatus for decomposing error contributions from multiple sources to multiple features of a pattern printed on a substrate, the apparatus comprising:

a memory storing a set of instructions; and

at least one processor configured to execute the set of instructions to cause the apparatus to perform a method of:

obtaining an image of the pattern on the substrate;

obtaining, using the image, a plurality of measurement values of a feature of the pattern, wherein the measurement values are obtained for different sensor values;

correlating, using a decomposition method, each measurement value of the plurality of measurement values to a linear mixture of the error contributions to generate a plurality of linear mixtures of the error contributions; and

deriving, from the linear mixtures and using the decomposition method, each of the error contributions.

40. The apparatus of clause 39, wherein the different sensor values correspond to different threshold values associated with the image in which each threshold value corresponds to a threshold of a pixel value in the image.

41. The apparatus of clause 40, wherein each measurement value corresponds to a critical dimension (CD) value of the feature at one of the different threshold values.

42. The apparatus of clause 40, wherein the error contributions include:

an image acquisition tool error contribution that is associated with an image acquisition tool used to acquire the image,

a mask error contribution that is associated with a mask used to print the pattern on the substrate, and

a resist error contribution that is associated with a resist used to print the pattern, wherein the resist error contribution includes photoresist chemical noise and a shot noise associated with a source of a lithographic apparatus used to print the pattern.

43. The apparatus of clause 42 further comprising:
adjusting, based on the mask error contribution, one or more parameters of at least one of the mask or a source of a lithographic apparatus used to print the pattern.

44. The apparatus of clause 42 further comprising:
adjusting, based on the resist error contribution, one or more parameters of at least one of the mask or a source of a lithographic apparatus used to print the pattern.

45. The apparatus of any of clauses 41-44, wherein obtaining the measurement values includes:

obtaining a first signal having a first plurality of delta CD values from a plurality of measurement points at a first threshold value of the different threshold values,

obtaining a second signal having a second plurality of delta CD values from the plurality of measurement points at a second threshold value of the different threshold values, and

obtaining a third signal having a third plurality of delta CD values from the plurality of measurement points at a third threshold value of the different threshold values.

46. The apparatus of clause 45, wherein each delta CD value is determined per threshold value and per measurement point, and indicates a deviation of a CD value of a given feature from a mean value of a plurality of CD values of the features.

47. The apparatus of clause 45, wherein each delta CD value indicates, at a given threshold value, a distance between a specified point on a contour of a given feature to a reference point on a reference contour of the given feature, wherein the reference contour is a simulated version of the contour of the given feature.

48. The apparatus of clause 45, wherein correlating each measurement value includes:

correlating each of the first plurality of delta CD values in the first signal to a first linear mixture of the image acquisition tool, mask and resist error contributions,

correlating each of the second plurality of delta CD values in the second signal to a second linear mixture of the image acquisition tool, mask and resist error contributions, and

correlating each of the third plurality of delta CD values in the third signal to a third linear mixture of the image acquisition tool, mask and resist error contributions.

49. The apparatus of clause 48, wherein deriving each of the error contributions includes:
deriving, using the first, second, and third linear mixtures, (a) a first output signal having a plurality of the image acquisition tool error contributions, (b) a second output signal having a plurality of the mask error contributions, and (c) a third output signal having a plurality of the resist error contributions from each of the first plurality, second plurality, and third plurality of delta CD values.

50. The apparatus of clause 49, wherein deriving each of the error contributions includes:
deriving each of the error contributions using independent component analysis (ICA) method.

51. The apparatus of clause 50, wherein deriving each of the error contributions using the ICA method includes:

determining a mixing matrix having a set of coefficients that generates the first, second and third linear mixtures of the error contributions corresponding to each delta CD value from the first plurality, second plurality and third plurality of delta CD values, respectively,

determining an inverse of the mixing matrix, and

using the inverse of the mixing matrix, determining (a) the first output signal having the plurality of the image acquisition tool error contributions, (b) the second output signal having the plurality of the mask error contributions, and (c) the third output signal having the plurality of the resist error contributions, from the first plurality, second plurality and third plurality of delta CD values, respectively.

52. The apparatus of clause 49, wherein deriving each of the error contributions includes:
deriving each of the error contributions using reconstruction ICA method, or orthonormal ICA method.

53. The apparatus of any of clauses 40-41, wherein obtaining the measurement values includes:

obtaining a first contour of the feature corresponding to a first threshold value of the different threshold values,
obtaining a first CD value of the first contour,
obtaining a second contour of the feature corresponding to a second threshold value of the different threshold values, and
obtaining a second CD value of the second contour.

54. The apparatus of clause 53 further comprising:
obtaining a first delta CD value of the first CD value, wherein the first delta CD indicates a deviation of the first CD value from a mean of a plurality of first CD values measured at a plurality of measurement points at the first threshold value.

55. The apparatus of clause 54, wherein obtaining the first delta CD value includes:

obtaining the plurality of first CD values corresponding to the first threshold value at the plurality of measurement points,
obtaining a mean value of the plurality of first CD values,
shifting the mean value to a zero value, and
obtaining the first delta CD value as a difference between the first CD value and the mean value.

56. The apparatus of clause 55, wherein the plurality of measurement points are located on at least one of (a) the feature or (b) a plurality of features of the pattern.

57. The apparatus of any of clauses 53-55, wherein correlating each measurement value includes:

correlating the first delta CD value corresponding to the first threshold value to a first linear mixture of a first error contribution and a second error contribution of the error contributions, and
correlating a second delta CD value corresponding to the second threshold value to a second linear mixture of the first and second error contributions.

58. The apparatus of clause 57, wherein deriving each of the error contributions includes:
deriving, using the decomposition method, the first and second error contributions from the first and second delta CD values, and the first and second linear mixtures.

59. The apparatus of clause 39, wherein the measurement values correspond to a local critical dimension uniformity (LCDU) value of the feature for the different sensor values.

60. The apparatus of any of clauses 39 and 60, wherein the different sensor values correspond to different dose levels associated with a source of a lithographic apparatus used to print the pattern.

61. The apparatus of any of clauses 39 and 60, wherein the different sensor values correspond to different focus levels associated with a source of a lithographic apparatus used to print the pattern.

62. The apparatus of any of clauses 59-60 further comprising:

obtaining, based on a specified focus level, a first LCDU value corresponding to a first dose level, and
obtaining, based on the specified focus level, a second LCDU value corresponding to a second dose level.

63. The apparatus of any of clauses 59 or 61 further comprising:

obtaining, based on a specified dose level, a first LCDU value corresponding to a first threshold value of a focus level, and
obtaining, based on the specified dose level, a second LCDU value corresponding to a second threshold value of the focus level.

64. The apparatus of any of clauses 62 or 63, wherein correlating each measurement value includes:

correlating the first LCDU value to a first linear mixture of a first error contribution of the error contributions and a second error contribution of the error contributions, and

correlating the second LCDU value to a second linear mixture of the first and second error contributions.

65. The apparatus of clause 64, wherein deriving each of the error contributions includes:
deriving, using the decomposition method, the first and second error contributions from the first and second LCDU values, and the first and second linear mixtures.
66. The apparatus of clause 39, wherein the measurement values correspond to a line width roughness (LWR) value of the feature for the different sensor values.

A computer program product comprising a non-transitory computer readable medium having instructions recorded thereon, the instructions when executed by a computer implementing the method of any of the above clauses.

The concepts disclosed herein may simulate or mathematically model any generic imaging system for imaging sub wavelength features, and may be especially useful with emerging imaging technologies capable of producing increasingly shorter wavelengths. Emerging technologies already in use include EUV (extreme ultra violet), DUV lithography that is capable of producing a 193nm wavelength with the use of an ArF laser, and even a 157nm wavelength with the use of a Fluorine laser. Moreover, EUV lithography is capable of producing wavelengths within a range of 20-5nm by using a synchrotron or by hitting a material (either solid or a plasma) with high energy electrons in order to produce photons within this range.

While the concepts disclosed herein may be used for imaging on a substrate such as a silicon wafer, it shall be understood that the disclosed concepts may be used with any type of lithographic imaging systems, e.g., those used for imaging on substrates other than silicon wafers.

As used herein, unless specifically stated otherwise, the term "or" encompasses all possible combinations, except where infeasible. For example, if it is stated that a database can include A or B, then, unless specifically stated otherwise or infeasible, the database can include A, or B, or A and B. As a second example, if it is stated that a database can include A, B, or C, then, unless specifically stated otherwise or infeasible, the database can include A, or B, or C, or A and B, or A and C, or B and C, or A and B and C.

The descriptions above are intended to be illustrative, not limiting. Thus, it will be apparent to one skilled in the art that modifications may be made as described without departing from the scope of the claims set out below.

**Claims**

1. A non-transitory computer-readable medium having instructions that, when executed by a computer, cause the computer to execute a method for decomposing error contributions from multiple sources to multiple features of a pattern printed on a substrate, the method comprising:

   obtaining an image of the pattern on the substrate;
   obtaining, using the image, a plurality of measurement values of a feature of the pattern, wherein the measurement values are obtained for different sensor values;
   correlating, using a decomposition method, each measurement value of the plurality of measurement values to a linear mixture of the error contributions to generate a plurality of linear mixtures of the error contributions; and
   deriving, from the linear mixtures and using the decomposition method, each of the error contributions.

2. The computer-readable medium of claim 1, wherein the different sensor values correspond to different threshold values associated with the image in which each threshold value corresponds to a threshold of a pixel value in the image.

3. The computer-readable medium of claim 2, wherein each measurement value corresponds to a critical dimension (CD) value of the feature at one of the different threshold values.

4. The computer-readable medium of claim 2, wherein the error contributions include:

   an image acquisition tool error contribution that is associated with an image acquisition tool used to acquire the image,
   a mask error contribution that is associated with a mask used to print the pattern on the substrate, and
   a resist error contribution that is associated with a resist used to print the pattern, wherein the resist error contribution includes photoresist chemical noise and a shot noise associated with a source of a lithographic apparatus used to print the pattern.

**5.** The computer-readable medium of claim 4 further comprising:
adjusting, based on the mask error contribution, one or more parameters of at least one of the mask or a source of a lithographic apparatus used to print the pattern.

**6.** The computer-readable medium of claim 4 further comprising:
adjusting, based on the resist error contribution, one or more parameters of at least one of the mask or a source of a lithographic apparatus used to print the pattern.

**7.** The computer-readable medium of claim 3, wherein obtaining the measurement values includes:

obtaining a first signal having a first plurality of delta CD values from a plurality of measurement points at a first threshold value of the different threshold values,
obtaining a second signal having a second plurality of delta CD values from the plurality of measurement points at a second threshold value of the different threshold values, and
obtaining a third signal having a third plurality of delta CD values from the plurality of measurement points at a third threshold value of the different threshold values.

**8.** The computer-readable medium of claim 7, wherein each delta CD value is determined per threshold value and per measurement point, and indicates a deviation of a CD value of a given feature from a mean value of a plurality of CD values of the features.

**9.** The computer-readable medium of claim 7, wherein each delta CD value indicates, at a given threshold value, a distance between a specified point on a contour of a given feature to a reference point on a reference contour of the given feature, wherein the reference contour is a simulated version of the contour of the given feature.

**10.** The computer-readable medium of claim 7, wherein correlating each measurement value includes:

correlating each of the first plurality of delta CD values in the first signal to a first linear mixture of the image acquisition tool, mask and resist error contributions,
correlating each of the second plurality of delta CD values in the second signal to a second linear mixture of the image acquisition tool, mask and resist error contributions, and
correlating each of the third plurality of delta CD values in the third signal to a third linear mixture of the image acquisition tool, mask and resist error contributions.

**11.** The computer-readable medium of claim 10, wherein deriving each of the error contributions includes:
deriving, using the first, second, and third linear mixtures, and from each of the first plurality, second plurality, and third plurality of delta CD values: (a) a first output signal having a plurality of the image acquisition tool error contributions, (b) a second output signal having a plurality of the mask error contributions, and (c) a third output signal having a plurality of the resist error contributions.

**12.** The computer-readable medium of claim 11, wherein each error contribution is determined as a function of the corresponding error contribution at the first, second and third threshold levels.

**13.** The computer-readable medium of claim 11, wherein deriving each of the error contributions includes:

determining a mixing matrix having a set of coefficients that generates the first, second and third linear mixtures of the error contributions corresponding to each delta CD value from the first plurality, second plurality and third plurality of delta CD values, respectively,
determining an inverse of the mixing matrix, and
using the inverse of the mixing matrix, determining (a) the first output signal having the plurality of the image acquisition tool error contributions, (b) the second output signal having the plurality of the mask error contributions, and (c) the third output signal having the plurality of the resist error contributions, from the first plurality, second plurality and third plurality of delta CD values, respectively.

**14.** The computer-readable medium of claim 2, wherein the obtaining the measurement values includes:

obtaining a first contour of the feature corresponding to a first threshold value of the different threshold values,
obtaining a first CD value of the first contour,

obtaining a second contour of the feature corresponding to a second threshold value of the different threshold values, and

obtaining a second CD value of the second contour.

15. An apparatus for decomposing error contributions from multiple sources to multiple features of a pattern printed on a substrate, the apparatus comprising:

a memory storing a set of instructions; and
at least one processor configured to execute the set of instructions to cause the apparatus to perform a method of:

obtaining an image of the pattern on the substrate;
obtaining, using the image, a plurality of measurement values of a feature of the pattern, wherein the measurement values are obtained for different sensor values;
correlating, using a decomposition method, each measurement value of the plurality of measurement values to a linear mixture of the error contributions to generate a plurality of linear mixtures of the error contributions; and
deriving, from the linear mixtures and using the decomposition method, each of the error contributions.

FIG. 1

**FIG. 2**

**FIG. 3**

**FIG. 4**

**FIG. 5**

EP 3 910 418 A1

FIG. 6

FIG. 7A

FIG. 7B

800

805

801

810

811

815

816

820

821

850

855

613

860

614

865

**FIG. 8A**

**FIG. 8B**

900

905

910

906

915

515, 520, 525

920

916

925

515a, 520a,
525a

**FIG. 9**

906c

1005

906b

906a

1050

1051

Scaled SEM
signal

X

FIG. 10

**FIG. 11**

FIG. 12

**FIG. 13**

FIG. 14

**FIG. 15A**

```
┌─────────┐         ┌─────────┐
│  S802   │         │  S810   │◄─────┐
└────┬────┘         └────┬────┘      │
     │                   │           │
     ▼                   ▼           │
┌─────────┐         ┌─────────┐      │
│  S804   │         │  S812   │      │
└────┬────┘         └────┬────┘      │
     │                   │           │
     ▼                   ▼           │
┌─────────┐          ╱───────╲       │
│  S806   │         ╱  S814    ╲────►┌─────────┐
└────┬────┘         ╲          ╱     │  S816   │
     │               ╲───────╱      └─────────┘
     ▼                   │
┌─────────┐              ▼
│  S808   ├──────┐    ┌──────┐
└─────────┘      │    │ END  │
                 │    └──────┘
                 └────────►
```

# FIG. 15B

**FIG. 16**

**FIG. 17**

**FIG. 18**

**FIG. 19**

FIG. 20

**FIG. 21**

Europäisches
Patentamt

European
Patent Office

Office européen
des brevets

# EUROPEAN SEARCH REPORT

**Application Number**

EP 20 17 4556

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2017/102264 A1 (ASML NETHERLANDS BV [NL]) 22 June 2017 (2017-06-22) | 1,15 | INV.<br>G03F7/20<br>G06T7/00 |
| A | * paragraphs [0063] - [0071]; figures 5-9 * | 2-14 | |
| X | US 2011/153265 A1 (STAALS FRANK [NL] ET AL) 23 June 2011 (2011-06-23) | 1,15 | |
| A | * paragraphs [0072] - [0089]; figures 6-8 * | 2-14 | |
| X | US 2019/278188 A1 (YPMA ALEXANDER [NL] ET AL) 12 September 2019 (2019-09-12)<br>* paragraphs [0097] - [0127] *<br>* paragraph [0135] *<br>* paragraphs [0193] - [0194] * | 1,15 | |

**TECHNICAL FIELDS SEARCHED (IPC)**

G03F
G06T

The present search report has been drawn up for all claims

| Place of search | Date of completion of the search | Examiner |
|---|---|---|
| Munich | 30 October 2020 | van Toledo, Wiebo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 20 17 4556

This annex lists the patent family members relating to the patent documents cited in the above-mentioned European search report.
The members are as contained in the European Patent Office EDP file on
The European Patent Office is in no way liable for these particulars which are merely given for the purpose of information.

30-10-2020

| Patent document cited in search report | | Publication date | Patent family member(s) | | Publication date |
|---|---|---|---|---|---|
| WO 2017102264 | A1 | 22-06-2017 | KR | 20180095638 A | 27-08-2018 |
| | | | TW | 201732448 A | 16-09-2017 |
| | | | US | 2020192229 A1 | 18-06-2020 |
| | | | WO | 2017102264 A1 | 22-06-2017 |
| US 2011153265 | A1 | 23-06-2011 | CN | 102103330 A | 22-06-2011 |
| | | | JP | 5145405 B2 | 20-02-2013 |
| | | | JP | 2011142319 A | 21-07-2011 |
| | | | KR | 20110070798 A | 24-06-2011 |
| | | | TW | 201131314 A | 16-09-2011 |
| | | | US | 2011153265 A1 | 23-06-2011 |
| US 2019278188 | A1 | 12-09-2019 | CN | 105765461 A | 13-07-2016 |
| | | | KR | 20160067146 A | 13-06-2016 |
| | | | KR | 20180104187 A | 19-09-2018 |
| | | | KR | 20200073294 A | 23-06-2020 |
| | | | TW | 201516598 A | 01-05-2015 |
| | | | US | 2016246185 A1 | 25-08-2016 |
| | | | US | 2018253015 A1 | 06-09-2018 |
| | | | US | 2019278188 A1 | 12-09-2019 |
| | | | US | 2020264520 A1 | 20-08-2020 |
| | | | WO | 2015049087 A1 | 09-04-2015 |

EPO FORM P0459

For more details about this annex : see Official Journal of the European Patent Office, No. 12/82

## REFERENCES CITED IN THE DESCRIPTION

**Patent documents cited in the description**

- US 5969441 A
- US 5296891 A
- US 5523193 A
- US 5229872 A
- US 315849
- US 7587704 B

- US 815573 A
- US 2009065359 W
- WO 2010059954 A
- US 81345610
- US 20100315614

**Non-patent literature cited in the description**

- **C. SPENCE.** Full-Chip Lithography Simulation and Design Analysis - How OPC Is Changing IC Design. *Proc. SPIE,* 2005, vol. 5751, 1-14
- **Y. CAO et al.** Optimized Hardware and Software For Fast, Full Chip Simulation. *Proc. SPIE,* 2005, vol. 5754 (405
- **ROSENBLUTH et al.** Optimum Mask and Source Patterns to Print A Given Shape. *Journal of Microlithography, Microfabrication, Microsystems,* 2002, vol. 1 (1), 13-20

- **GRANIK.** Source Optimization for Image Fidelity and Throughput. *Journal of Microlithography, Microfabrication, Microsystems,* 2004, vol. 3 (4), 509-522
- **SOCHA.** *Proc. SPIE,* 2005, vol. 5853, 180
- **JORGE NOCEDAL ; STEPHEN J. WRIGHT.** Numerical Optimization. Cambridge University Press